# EUROPÄISCHE PATENTSCHRIFT

(11) **EP 1 715 383 B1**
(45) Veröffentlichungstag und Bekanntmachung des Hinweises auf die Patenterteilung: **02.02.2011**
(21) Anmeldenummer: 06005361.8
(22) Anmeldetag: 16.03.2006
(51) Int. Cl.: G03F 7/20

(54) **Belichtungsanlage**
Exposure apparatus
Appareil d'exposition

(30) Priorität: 19.04.2005 DE 102005019144; 22.02.2006 DE 102006008075
(43) Veröffentlichungstag der Anmeldung: 25.10.2006
(73) Patentinhaber: KLEO AG, 9050 Appenzell (CH)
(72) Erfinder: Opower, Hans, Prof.Dr., 82152 Krailling (DE); Scharl, Stefan, Dipl.-Ing., 88142 Wasserburg (DE)
(74) Vertreter: Hoeger, Stellrecht & Partner Patentanwälte

(56) Entgegenhaltungen:
- WO-A-2004/074940
- US-A1- 2002 126 479
- US-B1- 6 368 756

## Beschreibung

Die Erfindung betrifft eine Belichtungsanlage für Substratkörper, die auf einer Substratoberfläche eine fotosensitive Beschichtung tragen, umfassend ein Maschinengestell, einen den Substratkörper tragenden Substratträger, und eine Belichtungseinrichtung, wobei der Substratkörper und die Belichtungseinrichtung relativ zueinander in einer zu einer Substratoberfläche parallelen ersten Richtung und in einer zur Substratoberfläche parallelen zweiten und quer zur ersten Richtung verlaufenden Richtung bewegbar sind, so dass durch diese Relativbewegung der Belichtungseinrichtung zur fotosensitiven Beschichtung in der ersten Richtung und in der zweiten Richtung die fotosensitive Beschichtung lokal selektiv durch von der Belichtungseinrichtung erzeugbare Belichtungsflecken belichtbar ist.

Bei derartigen Belichtungsanlagen besteht das Problem, dass die Positionierung der Belichtungseinrichtung relativ zu der fotosensitiven Beschichtung in der ersten und zweiten Richtung mit höchstmöglicher Präzision erfolgen muss, um durch Belichten der fotosensitiven Beschichtung möglichst präzise zweidimensionale belichtete Strukturen erzeugen zu können.

Diese Aufgabe wird bei einer Belichtungsanlage der eingangs beschriebenen Art erfindungsgemäß dadurch gelöst, dass die Belichtungseinrichtung einen in der zweiten Richtung bewegbaren Optikschlitten aufweist, auf dem eine Abbildungsoptik für die Belichtung des Substratkörpers angeordnet ist, dass die Belichtungseinrichtung eine an dem Maschinengestell getrennt von dem Optikschlitten angeordnete Lichtquelleneinheit mit einer Vielzahl von Lichtquellen aufweist, deren Strahlung in die Abbildungsoptik einkoppelbar ist, dass mindestens ein flexibles Lichtleiterbündel das Licht von der nichtquelleneinheit zur Optikeinheit führt und dass das Ende des Lichtleiterbündels durch eine Steuerungmittels einer einstellbaren Positioniereinrichtung relativ zur Abbildungs Optik positionierbar ist.

Der Vorteil der erfindungsgemäßen Lösung ist darin zu sehen, dass die sehr viel Wärme erzeugenden Lichtquellen von dem Optikschlitten und der Abbildungsoptik entkoppelt sind und somit auch im Wesentlichen ein Wärmeeintrag von den Lichtquellen in den Optikschlitten und die Abbildungsoptik vermieden werden kann, so dass der Optikschlitten und die Abbildungsoptik relativ zu der fotosensitiven Beschichtung präzise positioniert werden können, ohne dass die präzise Positionierung negativen Einflüssen aufgrund eines Wärmeeintrags von den Lichtquellen unterworfen ist.

Ferner ist damit auch der Aufwand, der erforderlich ist, um den Optikschlitten und die Abbildungsoptik auf einer im Wesentlichen konstanten Temperatur zu halten, weit geringer, da die Notwendigkeit, große, von den Lichtquellen erzeugte Wärmemengen abzuführen, nicht besteht.

Im Rahmen der Erfindung ist der Begriff "Licht" nicht auf elektromagnetische Strahlung im sichtbaren Bereich beschränkt, sondern unter "Licht" auch elektromagnetische Strahlung zu verstehen, die im ultravioletten Bereich oder infraroten Bereich liegt. Aus diesem Grund ist auch unter dem Begriff "Belichtung" eine Bestrahlung der unter den Begriff "Licht" fallenden elektromagnetischen Strahlung zu verstehen und auch unter einer "Lichtquelle" ist eine Quelle zu verstehen, die elektromagnetische Strahlung in dem unter den vorstehend definierten Begriff "Licht" fallenden Wellenlängenbereich erzeugt.

Besonders vorteilhaft im Hinblick auf eine möglichst hohe Präzision bei der Belichtung ist es, wenn die Lichtquelleneinheit der Belichtungseinrichtung getrennt von einer den Optikschlitten führenden Brücke angeordnet ist.

Diese Trennung der Lichtquelleneinheit von der Brücke hat ebenfalls den Vorteil, dass damit in das den Optikschlitten führende Element kein Wärmeeintrag durch die Lichtquelleneinheit erfolgt und somit dadurch bedingte Probleme hinsichtlich der Präzision der Führung des Optikschlittens vermieden werden.

Ferner ist es hinsichtlich der Anordnung der Lichtquelleneinheit relativ zur Brücke günstig, wenn die Lichtquelleneinheit auf einer Seite der Brücke angeordnet ist, um möglichst kurze Wege zur Übertragung des Lichts von der Lichtquelleneinheit auf den Optikschlitten zu erhalten.

Bei der erfindungsgemäßen Lösung ist es prinzipiell möglich, die Lichtquelleneinheit stationär oder beweglich am Maschinengestell anzuordnen, so dass diese in einfacher Weise gekühlt werden, und lediglich den Optikschlitten mit der Abbildungsoptik in der zweiten Richtung zu bewegen. Eine stationäre Anordnung der Lichtquellen macht es aufgrund der Bewegung des Optikschlittens erforderlich, die Strahlung der Lichtquellen über große Distanzen auf die Abbildungsoptik zu übertragen.

Besonders günstig ist es, um insbesondere einen möglichst kurzen Übertragungsweg für das Licht zu erhalten, wenn die Lichtquelleneinheit mit der Optikeinheit in der zweiten Richtung bewegbar ist, so dass insbesondere bei einer in der zweiten Richtung bewegbaren Optikeinheit ein sogenanntes Mitführen der Lichtquelleneinheit in dieser Richtung erfolgt.

Prinzipiell könnte dabei eine starre Kopplung vorgesehen sein. Besonders günstig ist es jedoch, wenn die Lichtquelleneinheit auf separaten für diese vorgesehenen Führungen geführt ist, so dass eine möglichst weitgehende thermische Entkopplung der Lichtquelleneinheit von den übrigen Teilen der Belichtungsanlage möglich ist.

Prinzipiell könnte die Lichtquelleneinheit starr gekoppelt mit der Optikeinheit in der zweiten Richtung bewegt werden. Aus Gründen einer möglichst hohen Präzision der Positionierung der Optikeinheit ist es jedoch vorteilhaft, wenn die Lichtquelleneinheit in der zweiten Richtung durch einen Linearantrieb bewegbar ist, so dass dieser eigens für die Lichtquelleneinheit vorgesehene Linearantrieb unabhängig von dem Antrieb der Optikeinheit in dieser Richtung arbeiten kann.

Damit besteht beispielsweise auch die Möglichkeit, die Lichtquelleneinheit in der zweiten Richtung nur näherungsweise synchron zur Optikeinheit zu positionieren ohne eine exakte Synchronität beizubehalten.

Besonders günstig ist es dabei, wenn der Lichtquellenschlitten so angetrieben ist, dass er den Bewegungen des Optikschlittens im Wesentlichen folgt.

Damit können die Übertragungswege der Strahlung von den Lichtquellen auf die Abbildungsoptik in optimaler Weise verkürzt werden, ohne die Vorteile der thermischen Entkopplung der Lichtquellen von der Abbildungsoptik aufzugeben.

Die Einkopplung der Strahlung von den Lichtquellen in die Abbildungsoptik lässt sich dann optimieren, wenn die Belichtungseinrichtung einen in der zweiten Richtung bewegbaren Lichtquellenschlitten aufweist, auf dem die Lichtquelleneinheit angeordnet ist.

Ein derartiger Lichtquellenschlitten hat nach wie vor die vorstehend genannten Vorteile der Entkopplung der Abbildungsoptik von den sehr viel Wärme erzeugenden Lichtquellen, andererseits aber auch noch den weiteren Vorteil, dass die Wege, über welche die Strahlung von den Lichtquellen in die Abbildungsoptik eingekoppelt werden muss, kürzer gehalten werden, nämlich dadurch, dass sich der Lichtquellenschlitten ebenfalls bewegen und zumindest teilweise den Bewegungen des Optikschlittens mit der Abbildungsoptik folgen kann.

Hinsichtlich der Wärmeabfuhr ist es besonders vorteilhaft, wenn die Lichtquelleneinheit auf außerhalb des Maschinengestells angeordneten Führungen bewegbar ist.

Die Lichtquelleneinheit kann dabei in unterschiedlicher Art und Weise angeordnet sein. Eine Möglichkeit sieht vor, die Lichtquelleneinheit oberhalb der Brücke anzuordnen.

Eine andere vorteilhafte Lösung sieht vor, dass die Lichtquelleneinheit seitlich neben einer Stirnseite der Brücke angeordnet ist.

Das Lichtleiterbündel könnte dabei freihängend angeordnet sein. Besonders günstig ist es jedoch, wenn das flexible Lichtleiterbündel in einer an der Brücke vorgesehenen und zum Optikschlitten führenden Schleppführung geführt ist.

Beispielsweise ist vorgesehen, dass die Schleppführung in einer an der Brücke vorgesehenen Aufnahme verläuft.

Dabei kann die Aufnahme als ein in der Brücke vorgesehener Kanal ausgebildet sein.

Um eine optimale Einkopplung der Strahlung der Lichtquellen in die Abbildungsoptik zu erhalten, ist vorzugsweise vorgesehen, dass die Abbildungsoptik über ein flexibles Lichtleiterbündel mit den Lichtquellen der Lichtquelleneinheit gekoppelt ist.

Derartige flexible Lichtleiter stellen eine sehr einfache Möglichkeit dar, die Strahlung der Lichtquellen in die Abbildungsoptik einzukoppeln und insbesondere eröffnen sie die Möglichkeit, eine präzise Abbildung durch die mit dem Optikschlitten bewegte Abbildungsoptik zu erreichen, da der Ort der Einkopplung der Strahlung in die Abbildungsoptik relativ zur Abbildungsoptik definiert vorgebbar ist.

Damit ist einerseits eine optimale Justierung des Eintritts der Strahlung in die Abbildungsoptik erreichbar, andererseits besteht aber auch noch die Möglichkeit, durch Variation der Position der Lichtleiter relativ zur Abbildungsoptik die von der Abbildungsoptik auf der fotosensitiven Beschichtung erzeugbaren Belichtungsflecken relativ zur Abbildungsoptik noch zu verschieben.

Vorzugsweise ist dabei die Positioniereinrichtung so ausgebildet, dass sie es erlaubt, mindestens einen von der Abbildungsoptik erzeugten Belichtungsfleck auf der fotosensitiven Beschichtung in mindestens einer zu einer Beschichtungsoberfläche parallelen Richtung, vorzugsweise in zwei zur Beschichtungsoberfläche parallelen, quer zueinander verlaufenden Richtungen, zu verschieben.

Dabei ist es besonders vorteilhaft, wenn die beiden quer zueinander verlaufenden Richtungen, längs welchen der Belichtungsfleck auf der fotosensitiven Beschichtung verschiebbar ist, mit der ersten Richtung und der zweiten Richtung zusammenfallen, längs welcher der Substratschlitten und der Optikschlitten bewegbar sind.

Eine weitere vorteilhafte Ausführungsform der Positioniereinrichtung sieht vor, dass mit der Positioniereinrichtung das Ende des Lichtleiterbündels relativ zur Abbildungsoptik derart bewegbar ist, dass ein Durchmesser des mindestens einen auf der fotosensitiven Beschichtung erzeugbaren Belichtungsflecks variierbar ist.

Um eine optimale Fokussierung des Lichts auf die fotosensitive Beschichtung zu erhalten, ist vorzugsweise vorgesehen, dass die Abbildungsoptik mit einem Autofokus versehen ist.

Hinsichtlich der Positioniereinrichtungen wurden bislang keine näheren Angaben gemacht. So können die Positioniereinrichtungen beispielsweise mechanische Linear- oder Kippantriebe sein.

Eine besonders günstige Lösung sieht jedoch vor, dass die Positioniereinrichtung einen Piezoantrieb als Stellantrieb umfasst. Ein derartiger Piezoantrieb eröffnet die Möglichkeit, relativ präzise und genau bei kleinen Verstellwegen zu positionieren.

Insbesondere eröffnet ein derartiger Piezoantrieb auch die Möglichkeit, diesen mit einem hochpräzisem Messsystem zu kombinieren.

Hinsichtlich der Ausbildung des Optikschlittens wurden bislang keine näheren Angaben gemacht. So kann die Abbildungsoptik starr auf dem Optikschlitten montiert sein.

Eine vorteilhafte Lösung sieht vor, dass der Optikschlitten eine die Abbildungsoptik umfassende Optikeinheit trägt, die relativ zum Optikschlitten bewegbar ist.

Insbesondere ist es dabei vorteilhaft, wenn die Optikeinheit relativ zum Optikschlitten in einer dritten, quer zur ersten und zweiten Richtung verlaufenden Richtung bewegbar ist, um durch Bewegen der Optikeinheit relativ zum Optikschlitten stets eine optimale Fokuslage des Belichtungsflecks bei der Belichtung des Substratkörpers zu erhalten.

Insbesondere erlaubt eine derartige Bewegbarkeit der Optikeinheit eine Anpassung der Position der Optikeinheit an unterschiedliche Dicken der Substratkörper, die auf dem Substratschlitten angeordnet werden können.

Somit ist in optimaler Weise eine Voreinstellung der Optikeinheit relativ zu der fotosensitiven Beschichtung auf dem Substratkörper möglich.

Um weiterhin auch bei gegebenenfalls variierender Substratdicke eine optimale Position der Fokuslage zu erhalten, ist die Abbildungsoptik mit einem Autofokussystem versehen, welches eine voreingestellte Fokussierung des Belichtungsflecks auf der fotosensitiven Beschichtung aufrechterhält.

Um bei der Belichtung der Markierungen auf dem Substratkörper beobachten zu können, ist insbesondere vorgesehen, dass die Optikeinheit eine mit der Abbildungsoptik gekoppelte Beobachtungsoptik umfasst, so dass mit der Beobachtungsoptik die Möglichkeit besteht, über die Abbildungsoptik die Belichtung der fotosensitiven Beschichtung zu verfolgen und zu überprüfen.

Damit für die Beobachtungsoptik ausreichend Licht zur Verfügung steht, ist ferner noch vorgesehen, dass die Beobachtungsoptik mit einer Beleuchtungsoptik versehen ist, die ebenfalls über die Abbildungsoptik den zu belichtenden Bereich der fotosensitiven Beschichtung so ausleuchtet, dass eine Beobachtung der Belichtung der Beschichtung über die Beobachtungsoptik möglich ist, jedoch aber auch so, dass die Ausleuchtung dieses Bereichs nicht zur chemischen Veränderung der fotosensitiven Beschichtung führen oder beitragen kann.

Hinsichtlich der Führung des Optikschlittens am Maschinengestell wurden bislang keine näheren Angaben gemacht.

So sieht eine vorteilhafte Lösung vor, dass der Optikschlitten an einer über einem Bewegungsraum von Substratschlitten und Substratkörper verlaufenden Führung am Maschinengestell geführt ist.

Diese Führung ist vorzugsweise als sich über den Bewegungsraum hinweg erstreckende Brücke ausgebildet.

Um eine möglichst präzise Belichtung der fotosensitiven Beschichtung zu erhalten, ist vorzugsweise ein Längsmesssystem vorgesehen, das beim Bewegen des Optikschlittens ständig die Position des Optikschlittens in der zweiten Richtung erfasst.

Damit kann die Position des Optikschlittens in der zweiten Richtung stets überprüft werden und entsprechend der tatsächlich gemessenen Position des Optikschlittens kann die Belichtung der fotosensitiven Beschichtung erfolgen.

Da selbst bei präziser Führung des Optikschlittens in der zweiten Richtung keine absolut geradlinige Bewegung des Optikschlittens in dieser Richtung erfolgt, ist vorzugsweise ein Quermesssystem vorgesehen, das beim Bewegen des Optikschlittens ständig die Positionen des Optikschlittens quer zur zweiten Richtung erfasst.

Somit besteht mit dem Quermesssystem auch die Möglichkeit, Führungsungenauigkeiten in der Führung des Optikschlittens zu erkennen und gegebenenfalls durch entsprechende Steuerung der Relativbewegung von Optikschlitten und Substratschlitten auszugleichen.

Besonders günstig ist es dabei, wenn das Quermesssystem die Positionen des Optikschlittens in der ersten Richtung erfasst, so dass in einfacher Weise die Möglichkeit einer Kompensation von Abweichungen der Bewegung des Optikschlittens in der ersten Richtung durch entsprechende Bewegung des Substratschlittens in der ersten Richtung möglich ist.

Vorzugsweise sind das Längsmesssystem und/oder auch das Quermesssystem optische Messeinrichtungen, welche insbesondere einen Lichtweg interferometrisch erfassen.

Beispielsweise wird bei derartigen interferometrischen Messeinrichtungen ein Lichtweg zwischen einem Sende- und Empfangskopf einerseits sowie einem Reflektor andererseits interferometrisch erfasst.

Bei dem Längsmesssystem ist zweckmäßigerweise der Sende- und Empfangskopf stationär angeordnet, während der Reflektor an dem Optikschlitten sitzt.

Im Gegensatz dazu ist beim Quermesssystem vorzugsweise vorgesehen, dass der Sende- und Empfangskopf auf dem Optikschlitten sitzt und der Reflektor stationär angeordnet ist, wobei der Reflektor in der zweiten Richtung, längs welcher sich der Optikschlitten bewegt, eine Ausdehnung aufweist, die mindestens dem Weg, den der Optikschlitten zurücklegt, entspricht.

Alternativ und ergänzend zur bislang beschriebenen Lösung wird bei einer Belichtungsanlage der eingangs genannten Art die eingangs genannte Aufgabe erfindungsgemäß dadurch gelöst, dass das Maschinengestell ein Fundament aufweist, an dem der Substratschlitten in der ersten Richtung bewegbar geführt ist.

Ein derartiges Fundament ist vorzugsweise so ausgebildet, dass es eine gegenüber dem Substratschlitten um ein Vielfaches, mindestens einen Faktor 100, größere Masse aufweist.

Zweckmäßigerweise ist ein derartiges Fundament aus Granit ausgebildet.

Zur Entkopplung von Schwingungen der Umgebung ist vorzugsweise vorgesehen, dass das Fundament auf schwingungsdämpfenden Stützen angeordnet ist.

Um die Belichtungseinrichtung in geeigneter Weise in der zweiten Richtung bewegen zu können, ist vorzugsweise vorgesehen, dass das Maschinengestell eine sich quer zur ersten Richtung erstreckende Brücke aufweist, an welcher ein Optikschlitten der Belichtungseinrichtung geführt ist.

Die Brücke könnte unabhängig vom Fundament am Maschinengestell angeordnet sein.

Besonders günstig ist es jedoch, wenn die Brücke auf dem Fundament angeordnet ist.

Zweckmäßigerweise ist die Brücke ebenfalls aus Granit ausgebildet.

Um die Länge des Fundaments in der ersten Richtung möglichst gering zu halten, ist vorzugsweise vorgesehen, dass der Substrattisch relativ zu der Brücke derart bewegbar ist, dass der Substrattisch nur auf einer Seite der Brücke vollständig unter der Brücke herausfahrbar ist.

Diese einseitige vollständige Herausfahrbarkeit des Substrattisches unter der Brücke ist erforderlich, um den Substratkörper vom Substrattisch entnehmen und einen weiteren Substratkörper auf den Substrattisch auflegen zu können.

Hinsichtlich des Antriebs des Substratschlittens wurden bislang keine näheren Angaben gemacht. So wäre es beispielsweise denkbar, den Substratschlitten durch pneumatische oder ähnliche Antriebe anzutreiben.

Eine vorteilhafte Lösung sieht vor, dass der Substratschlitten durch mindestens einen elektrischen Linearantrieb in der ersten Richtung bewegbar ist.

Um hohe Beschleunigungen des Substrattisches bei möglichst verdrehungsfreier Bewegung desselben zu erreichen, ist vorzugsweise vorgesehen, dass der Substrattisch durch zwei im Abstand voneinander angeordnete Linearantriebe in der ersten Richtung bewegbar ist, da damit durch die geeignete Ansteuerung beider Linearantriebe eine aktive Parallelführung des Substratschlittens erreichbar ist.

Ergänzend oder alternativ zu den bislang beschriebenen Ausführungsformen sieht eine weitere Lösung der eingangs genannten Aufgabe bei einer Belichtungsanlage der eingangs beschriebenen Art vor, dass der Substratschlitten als Tragwerkstruktur aufgebaut ist.

Eine derartige Tragwerkstruktur hat im Gegensatz zu einem Aufbau des Substratschlittens aus einem massiven Material den Vorteil einer hohen Steifigkeit bei geringer zu beschleunigender Masse.

Zweckmäßigerweise ist dabei vorgesehen, dass die Tragwerkstruktur des Substratschlittens mindestens eine Flächenstruktur und quer zur Flächenstruktur eine Versteifungsstruktur aus quer zu der Flächenstruktur verlaufenden Versteifungswänden aufweist.

Mit dieser Lösung ist eine optimale Steifigkeit des Substratschlittens bei möglichst geringer Masse erreichbar.

Vorzugsweise ist dabei die Flächenstruktur als obere und/oder untere Wand des Substratschlittens ausgebildet, während die Versteifungswände senkrecht zu dieser Wand verlaufen.

Insbesondere sind dabei mehrere Versteifungswände vorgesehen, die miteinander verbunden sind und eine zusammenhängende Gitterstruktur bilden, die mit der Flächenstruktur verbunden ist.

Hinsichtlich des Materials für den Substratschlitten wurden bislang keine näheren Angaben gemacht. So ist es besonders günstig, wenn der Substratschlitten aus einem Leichtbaumaterial hergestellt ist.

Besonders geeignet als Leichtbaumaterial für den Substratschlitten hat sich dabei ein faserverstärktes Material, insbesondere ein kohlefaserverstärktes Material erwiesen.

Zweckmäßigerweise ist der Substratschlitten aus C/SiC-Material hergestellt.

Um den Antrieb des Substratschlittens möglichst optimal zu gestalten, ist vorgesehen, dass direkt am Substratschlitten ein Läufer des mindestens einen Linearantriebes angeordnet ist.

Zum Vermeiden eines Wärmeeintrages in den Substratschlitten und somit von Ungenauigkeiten aufgrund von Erwärmung des Substratschlittens, ist vorzugsweise vorgesehen, dass der mindestens eine Läufer im Bereich eines zur Montage desselben vorgesehenen Fußes gekühlt ist.

Vorzugsweise ist dabei die Kühlung der Läufer eine Flüssigkeitskühlung.

Im einfachsten Fall ist vorgesehen, dass der Fuß des mindestens einen Läufers mit Kühlkanälen durchsetzt ist.

Da der Substratschlitten trotz geringer Masse aufgrund der oszillierenden Hin-und Her-Bewegung durch Impulsübertragung auf das Fundament Schwingungen in diesem erzeugen könnte, ist vorzugsweise mindestens ein Impulsausgleichsschlitten vorgesehen, welcher im Wesentlichen gegenläufig zum Substratschlitten bewegbar ist, um den vom Substratschlitten beim Beschleunigen und Bremsen auf das Fundament übertragenen Impuls auszugleichen.

Besonders vorteilhaft ist es dabei, wenn der Substratschlitten zwischen zwei gegenläufig zu diesem bewegbaren Impulsausgleichsschlitten angeordnet ist.

Vorzugsweise ist dabei vorgesehen, dass der mindestens eine Impulsausgleichsschlitten durch einen elektrischen Linearantrieb angetrieben ist.

Im Falle eines elektrischen Linearantriebs ist es besonders zweckmäßig, wenn der mindestens eine Impulsausgleichsschlitten elektronisch gegenläufig mit dem Substratschlitten gekoppelt ist, so dass eine mechanische Kopplung entfallen kann.

Eine derartige elektronische Kopplung erlaubt außerdem auch noch eine Kompensation von unterschiedlich großen Impulsen des Substratschlitten, die dadurch entstehen können, dass der Substratkörper unterschiedliche Masse aufweisen kann.

Besonders vorteilhaft ist es für den Impulsausgleich, wenn ein Massenschwerpunkt des Substratschlittens und ein Massenschwerpunkt des mindestens einen Impulsausgleichsschlittens in einer gemeinsamen Ebene angeordnet sind, so dass beim Impulsausgleich auftretende quer zu der Ebene verlaufende Kräfte vermieden werden können.

Um auch die Position des Substratschlitten exakt erfassen zu können, ist vorzugsweise ein Längsmesssystem vorgesehen, welches beim Bewegen des Substratschlittens ständig die Position des Substratschlittens in der ersten Richtung erfasst.

Da trotz exakter Führung des Substratschlittens Bewegungen quer zur ersten Richtung auftreten können, ist vorzugsweise ein Quermesssystem vorgesehen, welches beim Bewegen des Substratschlittens ständig die Position des Substratschlittens quer zur ersten Richtung erfasst.

Insbesondere erfasst dabei das Quermesssystem die Bewegung des Substratschlittens in der zweiten Richtung.

Vorzugsweise sind das Längsmesssystem und/oder das Quermesssystem als optische Messsysteme ausgebildet, welche eine interferometrische Längenmessung vornehmen.

Die Präzision bei der Belichtung der fotosensitiven Beschichtung hängt jedoch bei einer Belichtungsanlage der eingangs beschriebenen Art nicht nur von der Präzision der Positionierung ab, sondern auch von der thermischen Stabilität der Belichtungsanlage.

Aus diesem Grund wird bei einer weiteren Ausführungsform einer Belichtungsanlage der eingangs beschriebenen Art die eingangs genannte Aufgabe dadurch gelöst, dass vorzugsweise über einem Bewegungsraum des Substratschlittens und des Substratkörpers mindestens ein Wärmetauscherelement angeordnet ist, welches einem in dem Bewegungsraum vorliegenden gasförmigen Kühlmedium Wärme entzieht.

Durch ein derartiges Wärmetauscherelement besteht die Möglichkeit, über einen großflächigen Bereich das Kühlmedium auf einer konstanten Temperatur zu halten, nämlich dadurch, dass diesem Wärme entzogen wird, die in das Kühlmedium durch die Belichtung der fotosensitiven Beschichtung des Substratkörpers und somit über den Substratkörper eingetragen wird.

Vorzugsweise sind dabei beidseitig im Anschluss an die Brücke über dem Bewegungsraum Wärmetauscherelemente vorgesehen.

Eine besonders vorteilhafte Wirkung des mindestens einen Wärmetauscherelements wird dann erreicht, wenn das Wärmetauscherelement sich in Richtung des Bewegungsraums erstreckende Wärmetauscherflächen aufweist.

Diese Wärmetauscherflächen erhöhen die für den Wärmeaustausch mit dem Kühlmedium zur Verfügung stehende Fläche und machen somit den Wärmeaustausch effektiver.

Besonders günstig ist es, wenn die Wärmetauscherflächen parallel zu einer vorgegebenen Richtung verlaufen.

Die vorgegebene Richtung ist dabei vorzugsweise die erste Richtung, in welcher sich der Substratschlitten beim Belichten der fotosensitiven Beschichtung oszillierend bewegt.

Insbesondere ist es dabei günstig, wenn die Wärmetauscherflächen so angeordnet sind, dass sich ein Strömungskanal ergibt, der in der vorgegebenen Richtung verläuft.

Das Wärmetauscherelement kann jedoch nicht nur zur Temperierung des in dem Bewegungsraum vorhandenen Kühlmediums vorgesehen sein, sondern auch dazu, einen weiteren Substratkörper zu temperieren.

Dabei kann das Wärmetauscherelement über ein zusätzliches beispielsweise gasförmiges Kühlmedium mit dem weiteren zu temperierenden Substratkörper in Kontakt sein.

Besonders vorteilhaft ist es jedoch, wenn das Wärmetauscherelement durch körperlichen Kontakt mit dem zu temperierenden Substratkörper wechselwirkt.

Im einfachsten Fall ist das Wärmetauscherelement als Träger für den zu temperierenden Substratkörper ausgebildet, so dass der Substratkörper auf dem Wärmetauscherelement aufliegt.

Zweckmäßigerweise liegt der Substratkörper dabei flächenhaft auf dem Wärmetauscherelement auf.

Ferner lässt sich die Temperierung des Substratschlittens mit dem zu belichtenden Substratkörper noch dadurch verbessern, dass der Bewegungsraum des Substratschlittens und des Substratkörpers von einem Strom eines temperaturstabilisierten gasförmigen Kühlmediums durchsetzt ist.

Ein derartiger Strom von gasförmigem Kühlmedium dient dazu, den Substratkörper mit der fotosensitiven Beschichtung trotz der beim Belichten derselben eingetragenen Energie auf einer im Wesentlichen konstanten Temperatur zu halten, um somit Deformationen, die durch Wärmedehnung auftreten könnten, zu vermeiden.

Besonders günstig ist es dabei, wenn der Strom des gasförmigen Kühlmediums eine Beschichtungsoberfläche der fotosensitiven Beschichtung überstreicht.

Um einen gerichteten Strom des gasförmigen Kühlmediums zu erhalten, ist vorgesehen, dass der Strom des gasförmigen Kühlmediums von einem Zufuhrkanal zu einem Abfuhrkanal verläuft.

Der Strom des Kühlmediums könnte dabei quer zur ersten Richtung verlaufen.

Insbesondere ist es dabei günstig, wenn der Strom des gasförmigen Kühlmediums längs des Bewegungsraums ungefähr parallel zur ersten Richtung verläuft.

Vorzugsweise ist in diesem Fall jeweils ein Zufuhrkanal in einem der Brücke gegenüberliegenden Endbereich des Maschinengestells angeordnet, so dass der Strom des gasförmigen Kühlmediums jeweils von dem der Brücke gegenüberliegenden Endbereich des Maschinengestells in Richtung der Brücke strömt.

Alternativ dazu ist vorgesehen, dass mindestens ein Zufuhrkanal im Bereich der Brücke angeordnet ist.

Zweckmäßigerweise ist ferner vorgesehen, dass der Abfuhrkanal im Bereich über der Brücke angeordnet ist, so dass der Strom des gasförmigen Kühlmediums auch noch die Brücke und insbesondere die Belichtungseinrichtung umströmen und kühlen kann.

Insbesondere wird dabei der Strom des gasförmigen Kühlmediums durch einen über der Brücke angeordneten Optikbewegungsraum geführt.

Um auch optimale Bedingungen hinsichtlich der Temperierung der Abbildungsoptik zu erhalten, ist vorzugsweise vorgesehen, dass der Strom des gasförmigen Kühlmediums in dem Optikbewegungsraum zunächst den Optikschlitten mit der Abbildungsoptik und dann die Lichtquelleneinheit umströmt, so dass die starke Erwärmung des Kühlmediums im Bereich der Lichtquelleneinheit sich nicht negativ auf die Temperatur der Abbildungsoptik oder des Substratkörpers auswirken kann.

Vorzugsweise durchläuft der Strom des gasförmigen Kühlmediums nach Abfuhr desselben durch den Abfuhrkanal eine Aufbereitungseinrichtung und wird von dieser dem Zufuhrkanal zugeführt.

Insbesondere bei Verwendung eines Wärmetauscherelements ist vorzugsweise vorgesehen, dass ein Strom des gasförmigen Kühlmediums auf einer dem Substratkörper auf dem Substratschlitten zugewandten Seite des Wärmetauscherelements entlangströmt.

Zweckmäßigerweise strömt dabei der Strom durch auf dieser Seite des Wärmetauscherelements angeordnete und durch die Wärmetauscherrippen gebildete Strömungskanäle.

Um ferner den zu temperierenden Substratkörper noch optimal temperieren zu können, ist vorgesehen, dass der auf dem Wärmetauscherelement angeordnete zu temperierende Substratkörper von einem Strom des gasförmigen Kühlmediums auf einer dem Substratschlitten abgewandten Seite überströmt ist.

Bei der bisher beschriebenen Führung des Stroms von gasförmigem Medium wurde nicht näher darauf eingegangen, wie dieser Strom gerichtet sein soll.

Grundsätzlich kann der Strom des gasförmigen Kühlmediums quer zur ersten Richtung verlaufen.

In Anpassung an die Bewegung des Substratschlittens ist es günstig, wenn der Strom des Kühlmediums ungefähr parallel zur ersten Richtung verläuft.

Eine Möglichkeit sieht weiter vor, den Strom des gasförmigen Mediums von den Enden des Fundamentkörpers zur Brücke zu führen.

Eine andere Möglichkeit sieht vor, den Strom das gasförmigen Kühlmediums von der Brücke zu den Enden des Fundamentkörpers zu führen.

Darüber hinaus ist bei den vorstehend beschriebenen Möglichkeiten in beiden Fällen vorgesehen, dass ein Teil des gasförmigen Kühlmediums auch den Optikraum durchsetzt, um die Optikeinheit, insbesondere die Abbildungsoptik, und die Lichtquelleneinheit aufeinanderfolgend zu temperieren bzw. zu kühlen.

Bei der Führung des Stroms aus gasförmigem Kühlmedium ist stets damit zu rechnen, dass dieser Strom auch Kleinstpartikel mitführt, die bei der Herstellung der belichteten Struktur zu Fehlern führen können.

Aus diesem Grund ist auch bei der Führung des Stroms des gasförmigen Kühlmediums vorteilhafterweise eine derartige Führung vorgesehen, die möglichst wenig Schmutz in den Bereich der Belichtung bewegt.

Eine Lösung sieht hierbei vor, dass das gasförmige Kühlmedium die Abbildungsoptik auf ihrer der Beschichtung zugewandten Seite unterströmt, um somit stets die Abbildungsoptik in dem der belichteten Struktur zugewandten Bereich frei von Schmutzpartikeln zu halten.

Eine günstige Lösung sieht hierbei vor, dass entlang der Positionen der Abbildungsoptik ein Zufuhrkanal für das gasförmige Kühlmedium vorgesehen ist, um unmittelbar nahe der der Beschichtung zugewandten Seite der Abbildungsoptik den Strom des gasförmigen Kühlmediums zuführen zu können, welcher die Abbildungsoptik auf ihrer der Beschichtung zugewandten Seite unterströmen soll.

Um bei der erfindungsgemäßen Belichtungsanlage die Substratkörper optimal in die Belichtungsanlage einbringen zu können, ist vorzugsweise ein Substratbeschickungstisch vorgesehen, über welchen Substratkörper der Belichtungsanlage zuführbar sind.

Ist nur ein Substratkörper dem Substratschlitten zuzuführen, so ist der Substratbeschickungstisch in Höhe des Substratschlittens angeordnet, so dass der Substratkörper in einer Ebene vom Substratbeschickungstisch auf den Substratschlitten oder umgekehrt verschiebbar ist.

Vorzugsweise ist dabei der Substratbeschickungstisch höhenverstellbar angeordnet, so dass der Substratbeschickungstisch einerseits so angeordnet werden kann, dass von diesem der Substratkörper entweder auf den Substratschlitten oder auf das Wärmetauscherelement bewegbar ist oder von einem der beiden entnommen werden kann.

Insbesondere ist dabei der Substratbeschickungstisch derart einstellbar, dass der Substratkörper ohne Höhenversatz in jeweils einer Ebene zwischen dem Substratbeschickungstisch und dem Substratschlitten oder dem Substratbeschickungstisch und dem Wärmetauscherelement verschiebbar ist.

Um die Verschiebbarkeit des Substratkörpers zu erleichtern, sind sowohl der Substratbeschickungstisch als auch der Substratschlitten oder der Substratbeschickungstisch und das Wärmetauscherelement mit Einrichtungen zur Erzeugung eines Luftpolsters versehen, so dass der jeweilige Substratkörper auf einem Luftpolster von dem Substratbeschickungstisch auf den Substratschlitten oder umgekehrt oder von dem Substratbeschickungstisch auf das Wärmetauscherelement oder umgekehrt bewegbar ist.

Im einfachsten Fall ist der Substratbeschickungstisch derart höhenverstellbar, dass er zwischen einer Höhe des Substratschlittens und einer Höhe des Wärmetauscherelements verstellbar ist.

Um den Substratkörper auf dem Substratschlitten fixieren zu können, sind vorzugsweise auf dem Substratschlitten Ansaugelemente vorgesehen, mit welchen der Substratkörper in einfacher Weise auf dem Substratschlitten durch Ansaugen fixierbar ist.

Weitere Merkmale und Vorteile der Erfindung sind Gegenstand der nachfolgenden Beschreibung sowie der zeichnerischen Darstellung einiger Ausführungsbeispiele. In der Zeichnung zeigen:
- Figur 1: eine perspektivische Ansicht einer erfindungsgemäßen Belichtungsanlage ohne äußere Verkleidung eines ersten Ausführungsbeispiels;
- Figur 2: eine Ansicht in Richtung des Pfeils A in Figur 1 des ersten Ausführungsbeispiels;
- Figur 3: einen Schnitt längs Linie 3-3 in Figur 2 des ersten Ausführungsbeispiels;
- Figur 4: eine vergrößerte Darstellung des Schnitts gemäß Figur 3 durch einen Substratschlitten des ersten Ausführungsbeispiels;
- Figur 5: einen Schnitt längs Linie 5-5 in Figur 4 des ersten Ausführungsbeispiels;

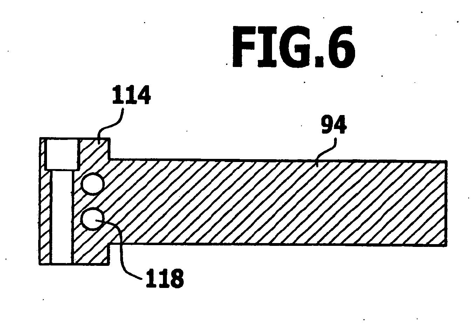

- Figur 6: einen Schnitt längs Linie 6-6 in Figur 4 des ersten Ausführungsbeispiels;
- Figur 7: eine perspektivische Darstellung eines Fundaments mit einem Substratschlitten ähnlich Figur 1, allerdings ohne Brücke und Belichtungseinrichtung sowie ohne Rahmen des ersten Ausführungsbeispiels;

- Figur 8: eine ausschnittsweise Vergrößerung einer Ansicht in Richtung des Pfeils B in Figur 1 des ersten Ausführungsbeispiels;
- Figur 9: eine weitere Vergrößerung des Bereichs C in Figur 8 des ersten Ausführungsbeispiels;
- Figur 10: eine teilweise geschnittene perspektivische Ansicht des Fundaments mit einer Brücke ähnlich Figur 1, allerdings ohne Optikschlitten und Abbildungsoptik und Rahmen des ersten Ausführungsbeispiels;
- Figur 11: einen Schnitt längs Linie 11-11 in Figur 10 des ersten Ausführungsbeispiels;
- Figur 12: eine Ansicht in Richtung des Pfeils D in Figur 1 des ersten Ausführungsbeispiels;
- Figur 13: einen Schnitt längs Linie 13-13 in Figur 1 des ersten Ausführungsbeispiels;
- Figur 14: eine perspektivische Darstellung eines Optikschlittens mit einer Optikeinheit des ersten Ausführungsbeispiels;
- Figur 15: eine perspektivische Darstellung eines Schnitts längs Linie 15-15 in Figur 14 des ersten Ausführungsbeispiels;
- Figur 16: eine perspektivische Darstellung eines Schnitts längs Linie 16-16 in Figur 14 des ersten Ausführungsbeispiels;

- Figur 17: eine Seitenansicht des Schnitts längs Linie 15-15 in Figur 14 des ersten Ausführungsbeispiels;
- Figur 18: eine Draufsicht auf den Schnitt in Richtung eines Pfeils E in Figur 13 mit Verhaubung des ersten Ausführungsbeispiels;
- Figur 19: einen Schnitt ähnlich Figur 18 durch ein Wärmetauscherelement des ersten Ausführungsbeispiels;
- Figur 20: eine Ansicht des Wärmetauscherelements in Richtung des Pfeils F in Figur 19 des ersten Ausführungsbeispiels;

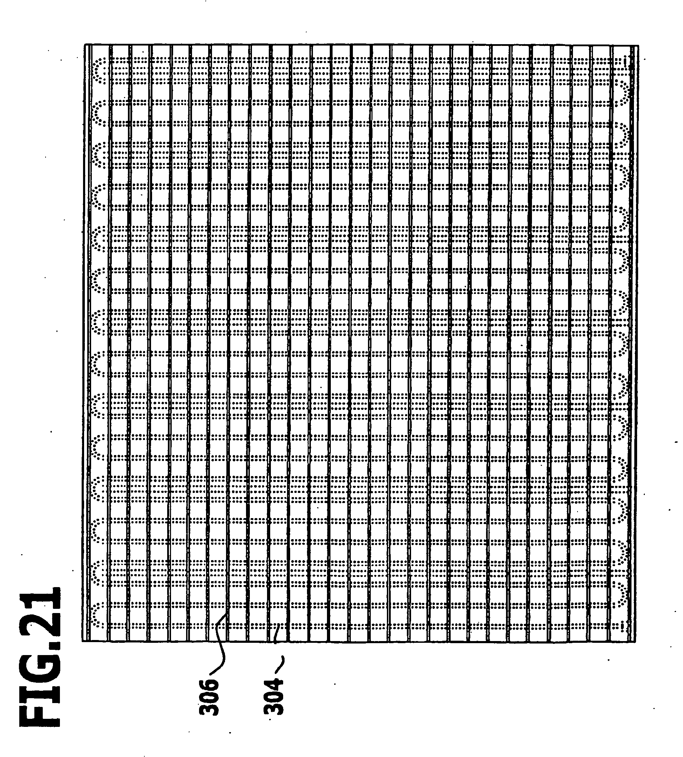

- Figur 21: eine Draufsicht auf das Wärmetauscherelement in Richtung eines Pfeils G in Figur 20 des ersten Ausführungsbeispiels;

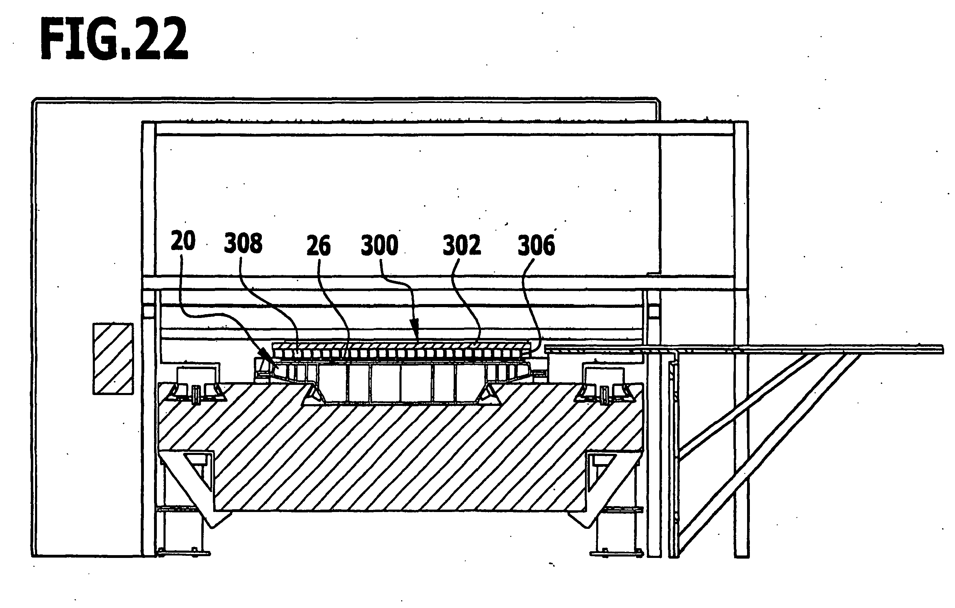

- Figur 22: einen Schnitt ähnlich Figur 2 bei einem Ausführungsbeispiel mit Hubtisch des ersten Ausführungsbeispiels;

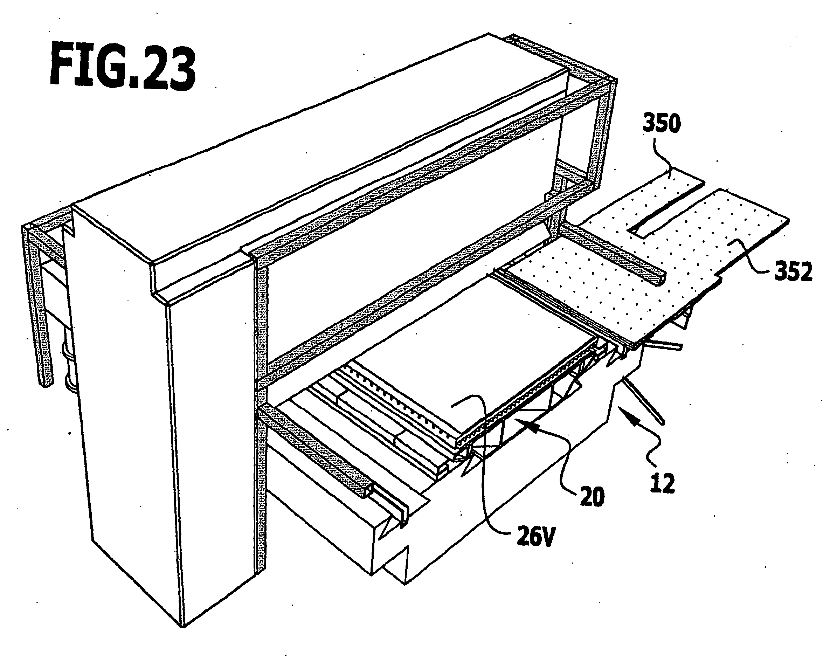

- Figur 23: eine perspektivische Darstellung des Schnitts gemäß Figur 22 des ersten Ausführungsbeispiels;
- Figur 24: eine ausschnittsweise vergrößerte Darstellung eines Bereichs H in Figur 19 des ersten Ausführungsbeispiels;
- Figur 25: eine Schnittdarstellung ähnlich Figur 18 bei einem zweiten Ausführungsbeispiel;

- Figur 26: einen Schnitt ähnlich Figur 17 durch den Optikschlitten mit Optikeinheit eines dritten Ausführungsbeispiels einer erfindungsgemäßen Belichtungsanlage;
- Figur 27: eine perspektivische Darstellung eines vierten Ausführungsbeispiels einer erfindungsgemäßen Belichtungsanlage;
- Figur 28: einen Schnitt ähnlich Figur 17 durch die Optikeinheit des vierten Ausführungsbeispiels;
- Figur 29: eine Draufsicht auf eine Aufnahmeeinheit der Optikeinheit des vierten Ausführungsbeispiels;
- Figur 30: eine Seitenansicht der Aufnahmeeinheit in Richtung des Pfeils I in Figur 29 und
- Figur 31: eine Darstellung ähnlich Figur 30 mit einer vergrößerten Darstellung der Bereiche I und K in Figur 30.

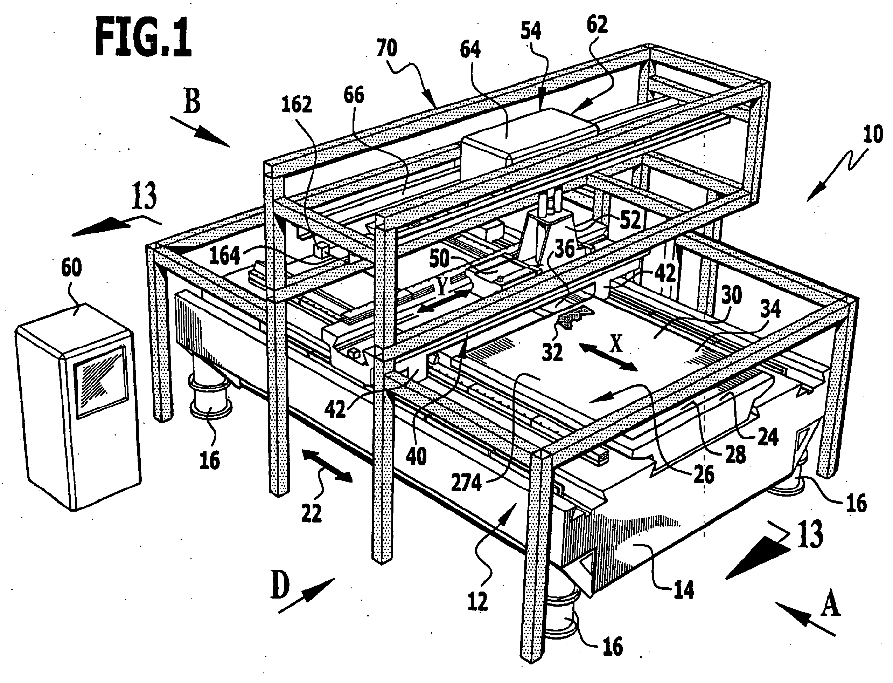

Ein Ausführungsbeispiel einer als Ganzes mit 10 bezeichneten erfindungsgemäßen Belichtungsanlage umfasst ein Maschinengestell 12 mit einem Fundamentkörper 14, welcher seinerseits auf schwingungsdämpfenden Stützen 16 angeordnet ist (Fig. 1).

Der Fundamentkörper 14 ist vorzugsweise aus Granit hergestellt und bietet daher mehrere Vorteile.

Ein Vorteil ist darin zu sehen, dass aufgrund des hohen spezifischen Gewichts der Fundamentkörper 14 eine große gegenüber externen und internen Schwingungen dämpfend wirkende Masse darstellt und dadurch insbesondere aufgrund der Stützen 16, die mit Dämpfungselementen versehen sind, vorteilhaft gegenüber externen Schwingungen entkoppelt werden kann.

Ferner hat ein derartiger Fundamentkörper 14 aus Granit den Vorteil, dass es sich bei Granit um ein verzugsfreies und hochgenau bearbeitbares Material handelt, das eine vorteilhafte Basis für die einzelnen Komponenten der hochpräzisen Belichtungsanlage darstellt.

An dem Fundamentkörper 14 ist ein als Ganzes mit 20 bezeichneter Substratschlitten in einer ersten Richtung X linear bewegbar geführt, wobei die erste Richtung X ungefähr parallel zu einer Längsrichtung 22 des Fundamentkörpers 14 und parallel zu einer Tragfläche 24 des Substratschlittens 20 verläuft.

Ferner ist auf der Tragfläche 24 des Substratschlittens 20 ein als Ganzes mit 26 bezeichneter Substratkörper positionierbar, welcher auf seiner der Tragfläche 24 abgewandten Substratoberfläche 28 mit einer fotosensitiven Beschichtung 30 versehen ist.

Die fotosensitive Beschichtung 30 kann dabei durch lokal gezielte Belichtung mit belichteten Strukturen 32 versehen werden, die sich beispielsweise bei einem nachfolgenden Ätzprozess gegenüber einer Ätzlösung anders verhalten als unbelichtete Bereiche 34 der Beschichtung 30.

Zur Erzeugung der belichteten Strukturen 32 ist der Substratschlitten 20 mit dem auf dessen Tragfläche 24 angeordneten Substratkörper 26 in einem über dem Fundamentkörper 14 liegenden und sich in der ersten Richtung X erstreckenden Bewegungsraum 36 bewegbar.

Auf dem Fundamentkörper 14 sitzt ferner eine als Ganzes mit 40 bezeichnete Brücke, die sich in einer quer zur ersten Richtung X verlaufenden zweiten Richtung Y über den Bewegungsraum 36 hinweg erstreckt und seitlich des Bewegungsraums 36 mit Brückenstützen 42 auf dem Fundamentkörper 14 abgestützt ist.

Vorzugsweise ist die Brücke 40 ebenfalls aus Granit hergestellt und weist somit dieselben Vorteile auf wie der Fundamentkörper 14.

An der Brücke 40 ist dabei ein als Ganzes mit 50 bezeichneter Optikschlitten geführt, welcher längs der Brücke 40 in der zweiten Richtung Y bewegbar ist und mindestens eine Abbildungsoptik 52 einer als Ganzes mit 54 bezeichneten Belichtungseinrichtung trägt, die in der zweiten Richtung Y relativ zum Substratschlitten 20 in einem Optikbewegungsraum 38 bewegbar ist, um in der Beschichtung 30 des Substratkörpers 26 durch gezielte lokale Belichtung in Verbindung mit einem Bewegen des Substratschlittens 20 und des Optikschlittens 50 zweidimensionale belichtete Strukturen 32 erzeugen zu können.

Das Erzeugen der belichteten Strukturen erfolgt beispielsweise so, wie in der WO 98/00760 beschrieben. Eine verbesserte Art der Belichtung der Beschichtung 30 ist in der EP 1 319 984 A2 beschrieben und eine weitere verbesserte Lösung in der WO 2004/029721 A2. Im Hinblick auf die Erzeugung der belichteten Strukturen 32, die Ausbildung der Abbildungsoptik und des Betriebs im Detail wird daher auf diese Druckschriften vollinhaltlich Bezug genommen.

US 6368 756 B1 offenbart eine Belichtungsanlage nach dem Oberbegriff des Anspruchs 1.

Sowohl die Bewegung des Substratschlittens 20 als auch die Bewegung des Optikschlittens 50 in Verbindung mit der gezielten lokalen Belichtung der Beschichtung 30 sind durch eine als Ganzes mit 60 bezeichnete Steuerung steuerbar, wobei die Steuerung 60 nach Vorgabe von Form und Größe der belichteten Struktur 32 selbsttätig die Belichtung der fotosensitiven Beschichtung 30 im Zusammenhang mit dem Bewegen des Substratschlittens 20 und des Optikschlittens 50 ausführt.

Bei dem dargestellten Ausführungsbeispiel ist die Belichtungseinrichtung 54 unterteilt in die Abbildungsoptik 52, die auf dem Optikschlitten 50 sitzt und eine Lichtquellen 61, insbesondere Laserlichtquellen, umfassende Lichtquelleneinheit 62, die auf einem Lichtquellenschlitten 64 sitzt, der seinerseits an Schlittenführungen 66 eines den Fundamentkörper 14 und die Brücke 40 übergreifenden Rahmens 70 des Maschinengestells 12 gehalten ist.

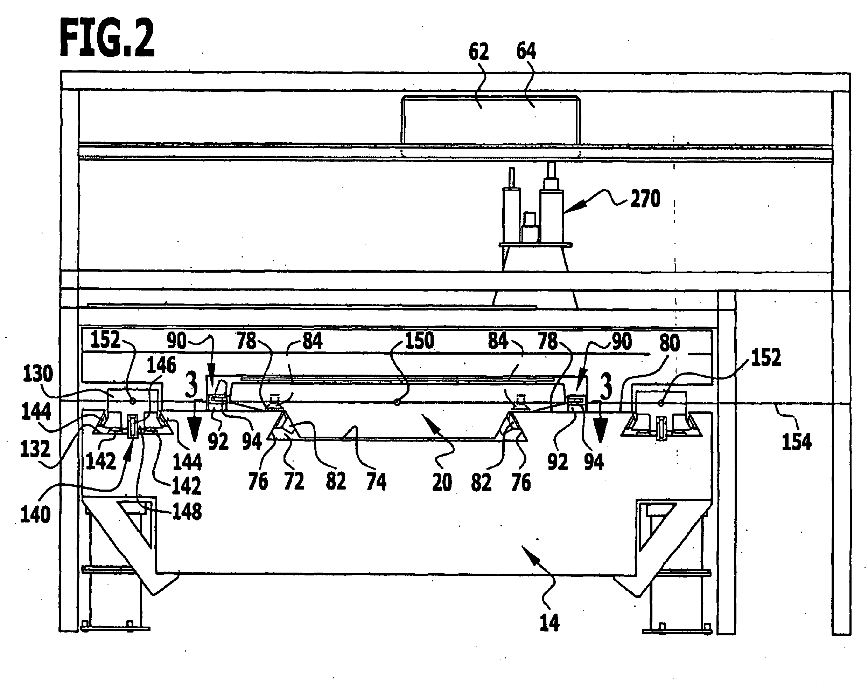

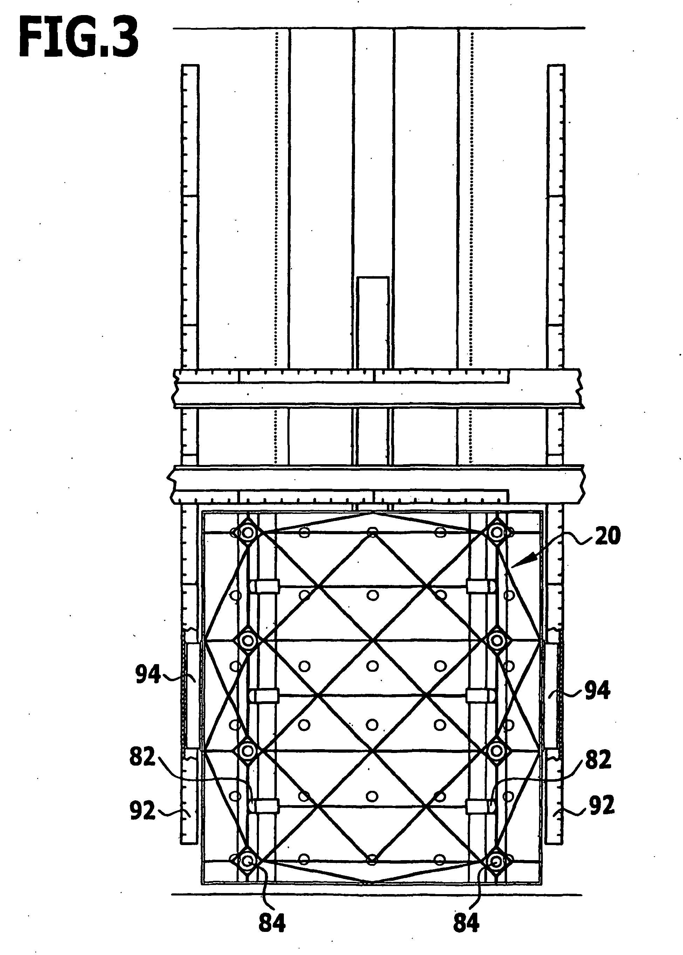

Wie im Detail in Figur 2 und 3 dargestellt, umfasst der Fundamentkörper 14 eine schwalbenschwanzförmige Ausnehmung 72 mit einer Grundfläche 74 und Seitenflächen 76, die von der Grundfläche 74 ausgehend sich von dieser weg erstrecken und dabei mit der Grundfläche 74 einen spitzen Winkel einschließen. Die Seitenflächen 76 erstrecken sich bis zu wiederum ungefähr parallel zur Grundfläche 74 verlaufenden Auflageflächen 78, die beispielsweise auf einer Oberseite 80 des Fundamentkörpers 14 angeordnet sind und mit den Seitenflächen 76 einen Winkel einschließen, der größer als 270° ist.

Vorzugsweise bilden dabei die Auflageflächen 78 und die Seitenflächen 76 Führungsflächen für die Führung des Substrattisches 20 in der ersten Richtung X, wobei der Substrattisch 20 auf den Seitenflächen 76 und den Auflageflächen 78 nicht vollflächig aufliegt, sondern an den Seitenflächen 76 gleitend geführte Gleitkörper 82 sowie an den Auflageflächen 78 gleitend geführte Gleitkörper 84 aufweist, wobei die Gleitkörper 82, 84 vorzugsweise so ausgebildet sind, dass sie ein Luftpolster auf den Seitenflächen 76 bzw. Auflageflächen 78 erzeugen und damit auf diesem Luftpolster gleiten.

Vorzugsweise sind die parallel zur ersten Richtung X verlaufenden Seitenflächen 76 sowie die Auflageflächen 78 unmittelbar an den Fundamentkörper 14 aus Granit angeschliffen, wie in Figur 2 dargestellt, oder der Fundamentkörper 14 aus Granit trägt seinerseits Leisten, die mit den Seitenflächen 76 bzw. den Auflageflächen 78 versehen sind, jedoch ihrerseits an dem Fundamentkörper 14 abgestützt sind, so dass dieser für die Steifigkeit derartiger Leisten maßgebend ist.

Zum Bewegen des Substratschlittens 20 sind sich in der ersten Richtung X erstreckende elektrische Linearantriebe 90 vorgesehen, die auf jeweils einander abgewandten Seiten der Auflageflächen 78 angeordnete Statorelemente 92 umfassen.

Vorzugsweise sind dabei die Statorelemente 92 ebenfalls unmittelbar an dem Fundamentkörper 14 angeordnet, beispielsweise auf geschliffenen Flächen desselben abstützt.

Ferner trägt der Substratschlitten 20 seitlich desselben angeordnete Läufer 94, welche durch die Statorelemente 92 der Linearantriebe 90 in der ersten Richtung X antreibbar und somit in dieser Richtung mitsamt dem Substratschlitten 20 bewegbar sind.

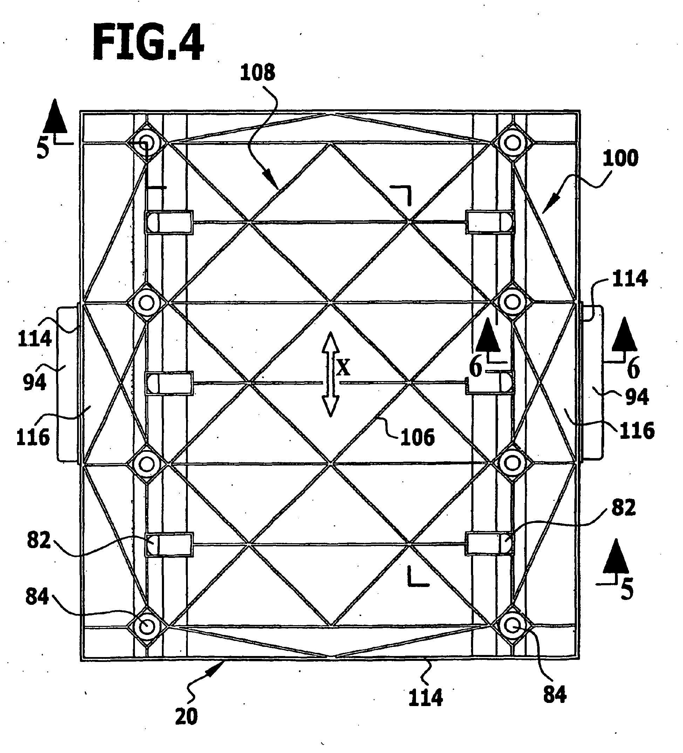

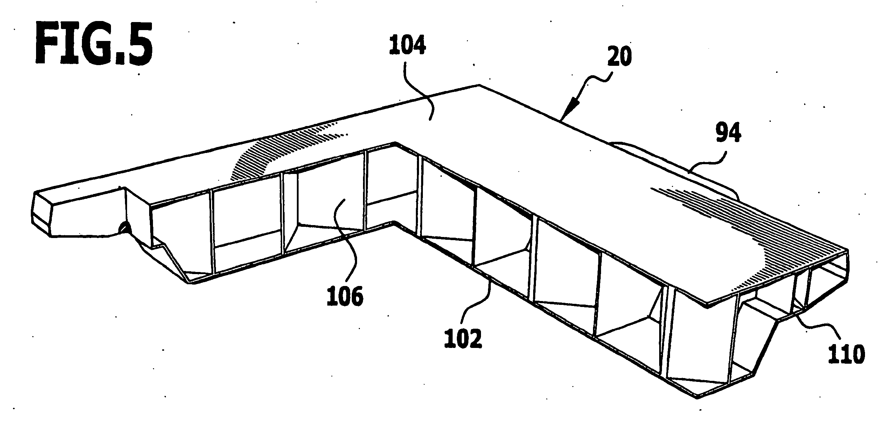

Wie in Figur 3 bis 5 dargestellt, ist der Substratschlitten 20 in der Art einer Tragwerkstruktur 100 aufgebaut, welche als untere Flächenstruktur eine Wand 102 und als obere die Tragfläche 24 bildende Flächenstruktur eine Wand 104 aufweist, die durch streifenförmig ausgebildete und ungefähr senkrecht zu diesen verlaufende Versteifungswände 106 miteinander verbunden sind, wobei die Versteifungswände 106, wie in Figur 4 dargestellt, zumindest zu einem nennenswerten Teil quer zu der ersten Richtung X verlaufen und entweder ungefähr einen rechten Winkel und/oder einen spitzen Winkel mit der ersten Richtung X einschließen, so dass sie zwischen der unteren Wand 102 und der oberen Wand 104 in wabenähnliche Hohlräume unterteilte Versteifungsstruktur 108 bilden.

Ferner ist die Tragwerkstruktur 100 noch seitlich durch Seitenwände 110 und endseitig durch Abschlusswände 112 abgeschlossen.

Außerdem ist in der Tragwerkstruktur 100 auch die Verankerung der Gleitkörper 82 und 84 integriert, so dass diese ebenfalls mit der der Tragwerkstruktur 100 innewohnenden Steifigkeit in dieser verankert sind.

Darüber hinaus erfolgt auch eine in die Tragwerkstruktur 100 integrierte Verankerung der Läufer 94, die mit Fußkörpern 114 an entsprechend durch die Versteifungsstruktur 108 versteiften Bereichen 116 der Seitenwände 110 montiert sind.

Vorzugsweise ist die gesamte Tragwerkstruktur 100 des Substratschlittens 20 als hochfeste Leichtbaukonstruktion ausgeführt, wobei die untere Wand 102, die obere Wand 104, die Versteifungswände 106 der Versteifungsstruktur 108 sowie die Seitenwände 110 und die Abschlusswände 112 aus kohlefaserverstärktem Siliciumcarbid C/SiC hergestellt sind, wodurch der Substratschlitten 20 einerseits eine möglichst hohe Steifigkeit bei möglichst geringer Masse desselben erhält. Dies hat zur Folge, dass die mechanischen Resonanzfrequenzen des Substrattisches 20 so hoch liegen, dass sie im Wesentlichen nicht bei oszillierendem Hin- und Herbewegen des Substratschlittens 20 angeregt werden.

Um außerdem mechanische Ungenauigkeiten durch Erwärmung des Substratschlittens 20 zu vermeiden, sind die an diesem sitzenden Läufer 94 insbesondere im Bereich ihrer Fußkörper 114 mit Kühlkanälen 118 versehen, durch welche ein Kühlmedium fließt, das die in den Läufern 94 entstehende Wärme möglichst weitgehend abführt, und so eine Erwärmung des Substrattisches 20 verhindern.

Um den Substrattisch 20 sowohl mit Kühlmedium für die Kühlkanäle 118 als auch mit Druckluft für die Gleitkörper 82, 84 versorgen zu können, ist der Substrattisch 20 mit einer Versorgungskette 120 verbunden, die in einer Aufnahme 122 in dem Fundamentkörper 14 verläuft und von einem fest mit dem Fundamentkörper 14 verbundenen Ende sich C-förmig zu dem Substratschlitten 20 erstreckt.

Obwohl der Substratschlitten 20 in Leichtbauweise erstellt ist, führt eine oszillierende Bewegung des Substratschlittens 20, angetrieben durch die Linearantriebe 90, zu einem Impulsübertrag auf den Fundamentkörper 14 und somit zu Schwingungen desselben.

Aus diesem Grund sind, wie in Figur 1, 2 und 7 dargestellt, beiderseits des Substratschlittens 20 Impulsausgleichsschlitten 130 vorgesehen, welche in einer schwalbenschwanzförmigen Ausnehmung 132 geführt sind, die eine Grundfläche 134 und zwei zu der Grundfläche 134 im spitzen Winkel geneigte Seitenführungsflächen 136 umfasst, an denen die Impulsausgleichsschlitten 130 in der ersten Richtung X linear bewegbar geführt sind.

Hierzu umfasst jeder Impulsausgleichsschlitten 130 zwei im Abstand voneinander angeordnete Gleitkörper 142, die auf der Grundfläche 134 gleitend aufsitzen und zwischen denen ein elektrischer Linearantrieb 140 angeordnet ist.

Ferner gleiten an den beiden Seitenführungsflächen 136 ebenfalls Gleitkörper 144, so dass der Impulsausgleichsschlitten 130 parallel zur ersten Richtung X in der Ausnehmung 132 geführt ist.

Die beiden Impulsausgleichsschlitten 130 weisen dabei eine Masse auf, die in Summe ungefähr der Masse des Substratschlittens 20 mit dem auf diesem angeordneten Substratkörper 26 entspricht.

Jeder Linearantrieb 140 ist dabei so ausgebildet, dass ein Stator 146 fest mit dem Fundamentkörper 14 verbunden ist und über die Grundfläche 134 der Ausnehmung 132 übersteht, wobei der Stator 146 von einem Läufer 148 umschlossen ist, der fest mit dem Impulsausgleichsschlitten 130 verbunden ist.

Der Linearantrieb 140 eines jeden der Impulsausgleichsschlitten 130 ist dabei elektronisch gegenläufig mit den Linearantrieben 90 des Substratschlittens 20 gekoppelt, so dass die beiden Impulsausgleichsschlitten 130 eine exakt gegenläufige Bewegung zum Substratschlitten 20 ausführen und somit den beim Beschleunigen und Abbremsen des Substratschlittens 20 auf den Fundamentkörper 14 wirkenden Impuls kompensieren.

Die Steuerung 60 kann dabei eine starre Kopplung vorsehen. Es ist jedoch aber auch denkbar, die Steuerung 60 so auszubilden, dass die relative Phase der Bewegungen der Impulsausgleichsschlitten 130 zum Substratkörper 20 sowie die Amplitude derselben und die maximale Geschwindigkeit derselben einstellbar ist, um eine optimale Impulskompensation zu erreichen.

Besonders vorteilhaft ist die Kompensation der Bewegungen des Substratschlittens 20 dann, wenn ein Massenschwerpunkt 150 des Substratschlittens und Massenschwerpunkte 152 der Impulsausgleichsschlitten in derselben Ebene 154 liegen, die parallel zu der ersten Richtung X verläuft, so dass dadurch eine optimale Impulskompensation möglich ist und im Wesentlichen keine Drehmomente auftreten.

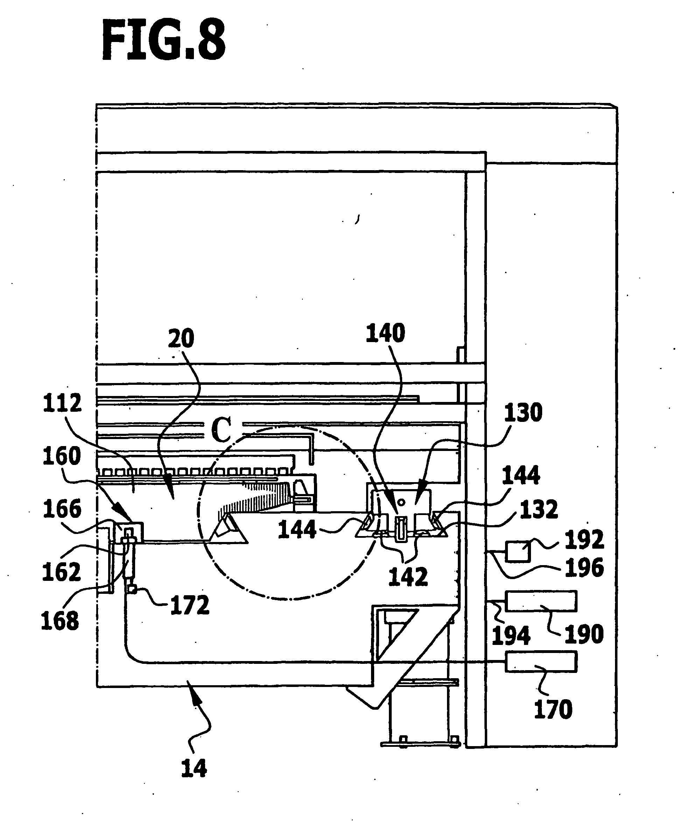

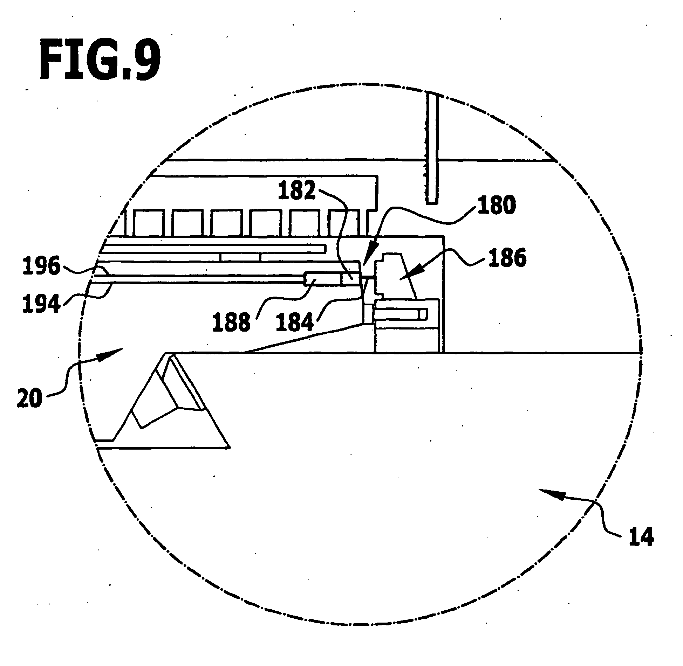

Zur Erfassung der Position des Substratschlittens 20 relativ zum Fundamentkörper 14 ist, wie in Figur 8 und 9 dargestellt, einerseits ein Längsmesssystem 160 vorgesehen, welches einen Sende- und Empfangskopf 162 für einen Laserstrahl 164 aufweist, der stationär am Fundamentkörper 14 gehalten ist und den Laserstrahl 164 auf einen Spiegel 166 am Substratschlitten 20, insbesondere an dessen Abschlusswand 112, richtet und den vom Spiegel 166 reflektierten Laserstrahl wieder empfängt und dabei über ein mit dem Sende- und Empfangskopf 162 gekoppeltes Interferometer 168 den Abstand zwischen dem Sende- und Empfangskopf 162 und dem Spiegel 166 und somit die Position des Substratschlittens 20 in der ersten Richtung X bestimmt.

Hierzu ist dem Längsmesssystem 160 noch ein wellenlängenstabilisierter Laser 170 zugeordnet, welcher die Laserstrahlung für das Längsmesssystem 160 erzeugt sowie ein Detektor 172, welcher die aus dem Interferometer 168 austretende Intensität detektiert.

Da die Führung des Substratschlittens 20 relativ zum Fundamentkörper 14 in der ersten Richtung X Abweichungen von einer absolut geradlinigen Führung aufweist, ist, wie in Figur 9 dargestellt, noch ein Quermesssystem 180 vorgesehen, welches die Bewegungen des Substratschlittens 20 in der zweiten Richtung Y, die senkrecht zur ersten Richtung X verläuft, erfasst.

Das Quermesssystem 180 umfasst ebenfalls einen Sende- und Empfangskopf 182, der in diesem Fall an dem Substratschlitten 20 angeordnet ist und einen Laserstrahl 184 aussendet, welcher auf einen stationär am Fundamentkörper 14 angeordneten Spiegel 186 trifft.

Bei dem Quermesssystem 180 hat dabei der Spiegel 186 eine Ausdehnung, die mindestens dem Weg entspricht, den der Sende- und Empfangskopf 182 bei Bewegung des Substratschlittens 20 zurücklegt, so dass sich der Spiegel 186 mindestens über die Länge der Bahn erstreckt, die der Laserstahl 184 bei Bewegen des Substratschlittens 20 in der ersten Richtung X durchläuft.

Darüber hinaus ist dem Sende- und Empfangskopf 182 noch ein Interferometer 188 zugeordnet, mit welchem interferometrisch der Abstand zwischen dem Sende- und Empfangskopf 182 und dem Spiegel 186 erfassbar ist.

Um jedoch mit den für das Quermesssystem 180 erforderlichen Laser 190 nicht mitbewegen zu müssen, sind sowohl der Laser 190 als auch ein Detektor 192 stationär angeordnet und über Lichtleiter 194 bzw. 196 über die Versorgungskette 120 mit dem Interferometer 188 und dem Sende- und Empfangskopf 182 verbunden, wobei die Laserstrahlung polarisationserhaltend über die Lichtleiter 194, 196 übertragen wird.

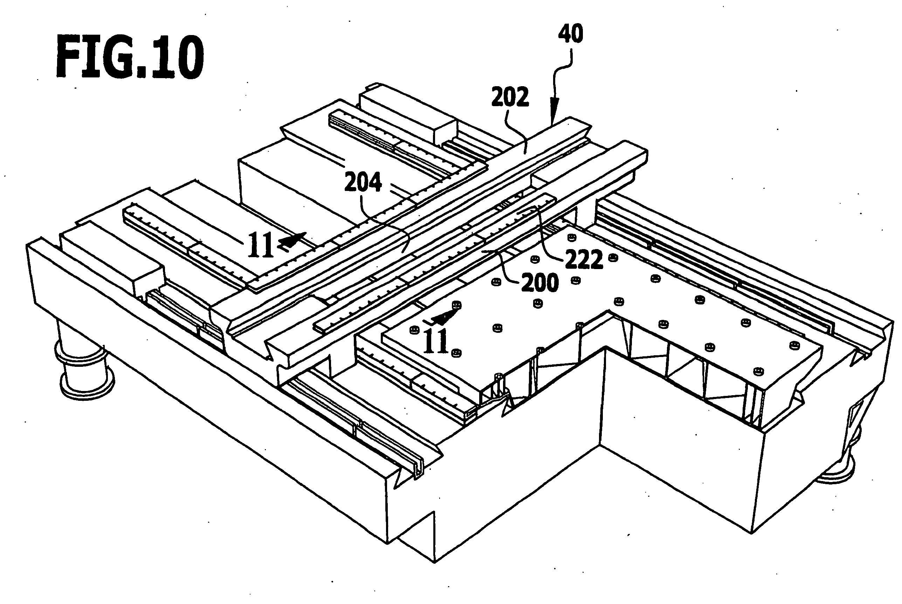

Wie in Figur 10 dargestellt, umfasst die Brücke 40 zwei parallele, jedoch im Abstand voneinander verlaufende Brückenträger 200, 202, zwischen denen ein Freiraum 204 vorgesehen ist, durch welchen eine Belichtung des auf dem Substratschlitten 20 oszillierend bewegten Substratkörpers 26 erfolgen kann.

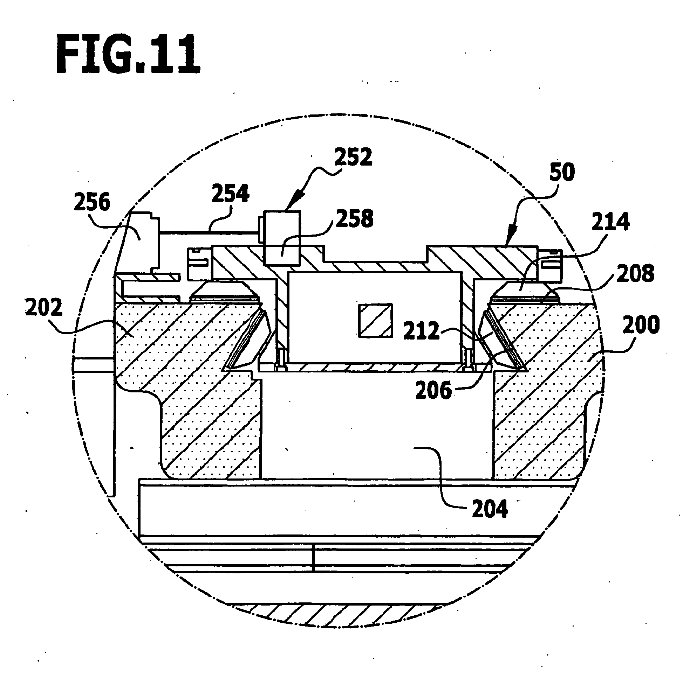

Jeder der beiden Brückenträger 200, 202 weist, wie in Figur 11 dargestellt, eine Seitenführungsfläche 206 und eine Auflagefläche 208 auf, auf denen Gleitkörper 212 und 214 mittels eines von diesen erzeugten Luftpolstern gleitend bewegbar sind.

Ferner schließen die Seitenführungsflächen 206 mit den Auflageflächen 208 einen Winkel von mehr als 270° ein, so dass der Optikschlitten 50 dadurch schwalbenschwanzähnlich an den beiden Brückenträgern 200, 202 geführt ist und somit die Gleitkörper 212 nicht nur zur Seitenführung beitragen, sondern auch eine Sicherung gegen ein Abheben der Gleitkörper 214 von den Auflageflächen 208 darstellen.

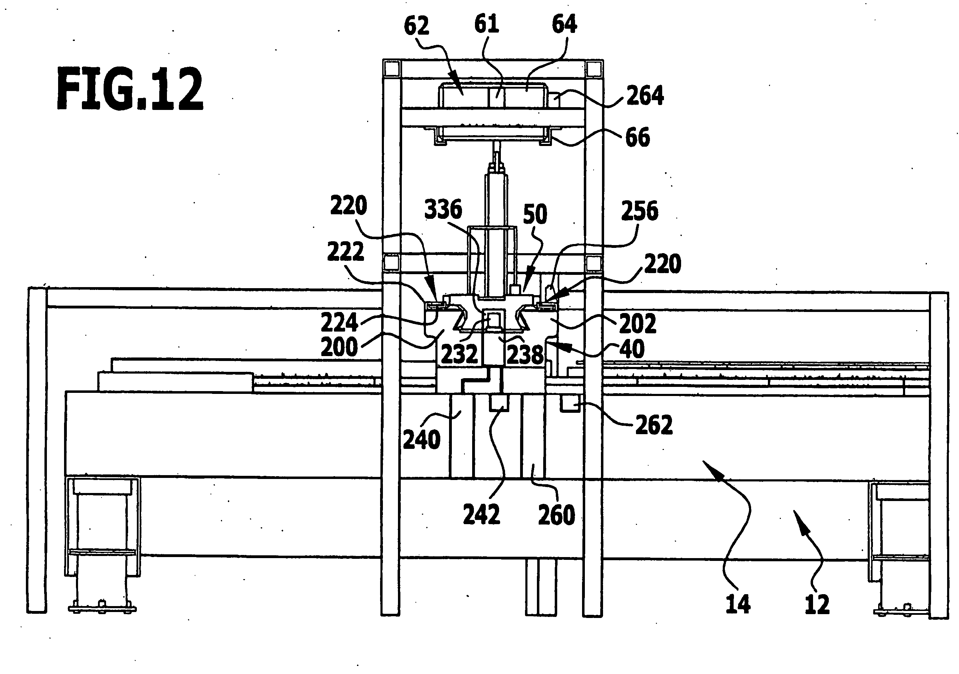

Der Antrieb des Optikschlittens 50 erfolgt, wie in Figur 10 und Figur 12 dargestellt, durch beiderseits desselben angeordnete elektrische Linearantriebe 220, deren Stator 222 auf jeweils einem der Brückenträger 200, 202 angeordnet ist, während ein Läufer 224 in den Stator 222 eingreift und mit dem Optikschlitten 50 jeweils verbunden ist.

Zur Erfassung der Position des Optikschlittens 50 ist ein Längsmesssystem 230 vorgesehen, welches einen Sende- und Empfangskopf 232 aufweist, der einen Laserstrahl 234 aussendet, wobei der Laserstrahl an einem Spiegel 236 des Optikschlittens 50 wieder zum Sende- und Empfangskopf 232 zurückreflektiert wird.

Ferner ist dem Sende- und Empfangskopf 232 ein Interferometer 238 zugeordnet, mit welchem der Abstand zwischen dem Sende- und Empfangskopf 232 und dem Spiegel 236 ermittelbar ist.

Der Laserstrahl 234 für das Längsmesssystem 230 wird erzeugt durch einen Laser 240 und das aus dem Interferometer 238 austretende Licht wird durch einen Detektor 242 detektiert.

Somit besteht für die Steuerung 60 die Möglichkeit, während der Bewegung des Optikschlittens 50 dessen Position in der zweiten Richtung Y stets exakt zu erfassen.

In gleicher Weise wird auch die Abweichung des Optikschlittens 50 quer zu einer geradlinigen Bewegung in der zweiten Richtung Y, wie in Figur 3 dargestellt, durch ein Quermesssystem 250 erfasst, welches einen auf dem Optikschlitten 50 angeordneten Sende- und Empfangskopf 252 aufweist, der

in bekannter Weise einen Laserstrahl 254 aussendet, welcher durch einen längs der Bewegungsbahn des Sende- und Empfangskopfs 252 sich erstreckenden Spiegel 256 reflektiert wird, wobei der Spiegel 256 stationär an dem Brückenträger 202 angeordnet ist.

Auch dem Sende- und Empfangskopf 252 der Quermesseinrichtung 250 ist ein Interferometer 258 zugeordnet, welches auf dem Optikschlitten 50 sitzt und somit mit diesem mitbewegt wird.

Allerdings sind auch im Fall des Optikschlittens 50 der Laser 260 zur Erzeugung des für interferometrische Messung erforderlichen Laserstrahls und in gleicher Weise auch der Detektor 262 stationär am Maschinengestell 12 angeordnet.

Mit der Quermesseinrichtung 250 ist es somit möglich, die Bewegung des Optikschlittens 50 quer, insbesondere senkrecht zur zweiten Richtung Y exakt zu erfassen und somit auch Führungsungenauigkeiten bei der Führung des Optikschlittens 50 an der Brücke 40 zu erkennen und gegebenenfalls über die Steuerung 60 - wie nachfolgend noch im Einzelnen beschrieben - zu korrigieren.

Wie außerdem in Figur 12 dargestellt, ist auch der Lichtquellenschlitten 64 durch einen Linearantrieb 264 antreibbar, und zwar ungefähr synchron mit dem Optikschlitten 50, allerdings mit einer weitaus geringeren Genauigkeit, so dass der Linearantrieb 264 lediglich eine Grobpositionierung des Lichtquellenschlittens 64 relativ zum Optikschlitten 50 und synchron zu diesem ermöglicht.

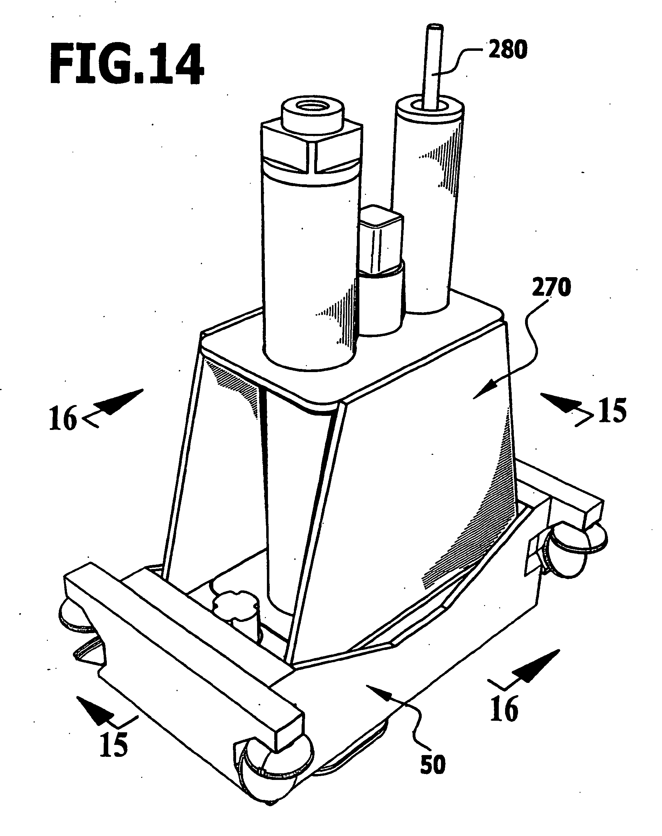

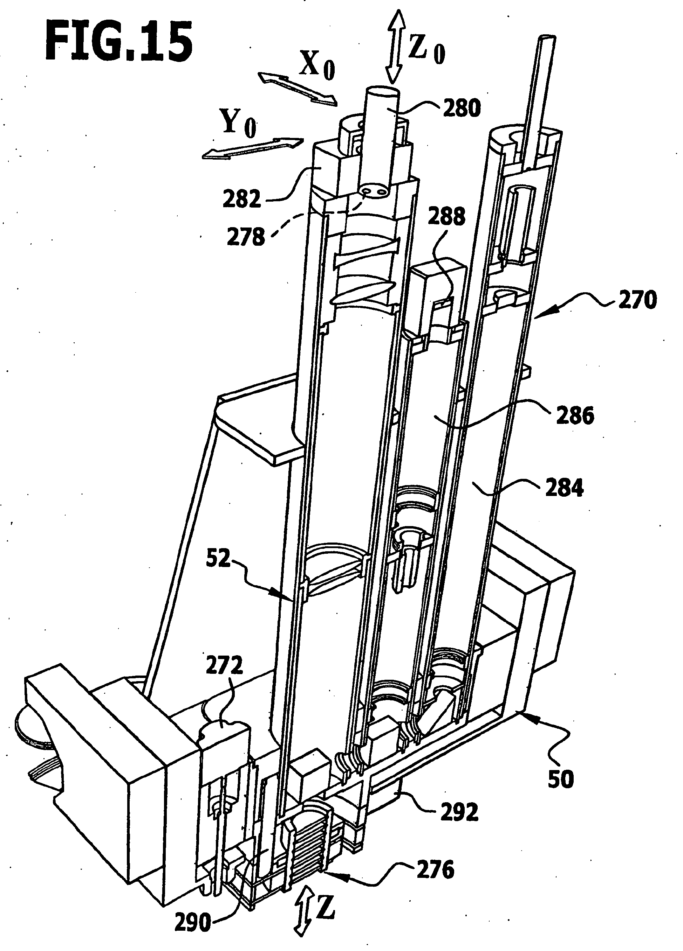

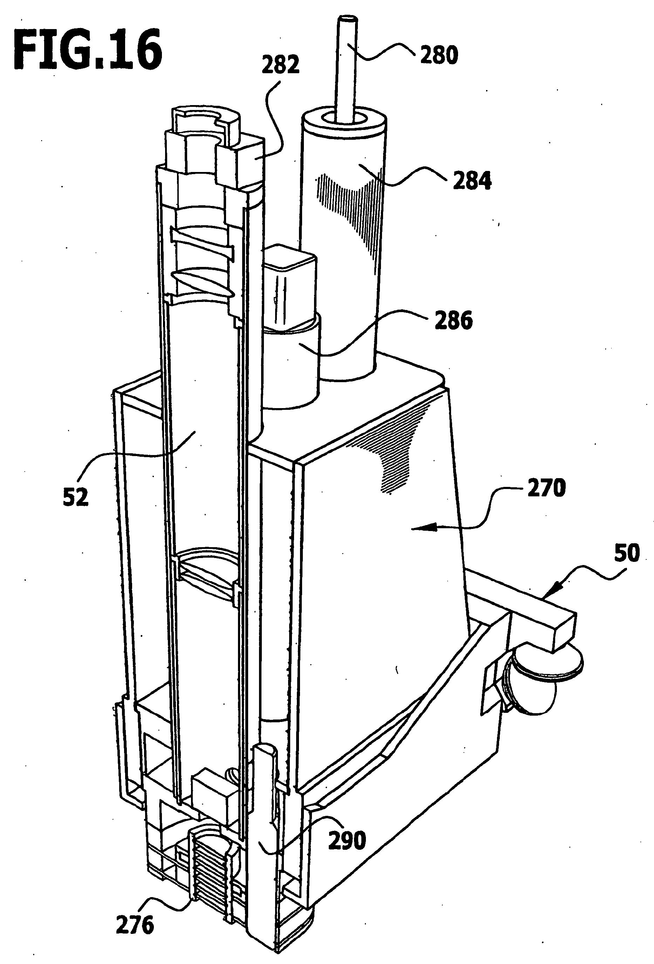

Wie in Figur 14 bis 17 dargestellt, ist auf dem Optikschlitten 50 eine relativ zum Optikschlitten 50 bewegbare Optikeinheit 270 angeordnet, welche durch einen Stellantrieb 272 in einer dritten Richtung Z, die senkrecht zu einer Beschichtungsoberfläche 274 und somit auch senkrecht zu der Oberseite 28 des Substratkörpers 26 verläuft, bewegbar ist, um einen Abstand zwischen einer Mikroskopoptik 276 der Abbildungsoptik 52 voreinzustellen.

Die Abbildungsoptik 52 umfasst ihrerseits ein mit der Mikroskopoptik 276 kombiniertes Linsensystem, welches in der Lage ist, einzelne Faserendflächen 278 eines Faserbündels 280 auf die Substratoberfläche 274 fokussiert abzubilden.

Zur exakten Positionierung der Faserenden 278 des Faserbündels 280 ist das Faserbündel 280 in einer als Ganzes mit 282 bezeichneten Positioniereinrichtung aufgenommen, welche in der Lage ist, das gesamte Faserbündel 280 und somit auch die Faserenden 278 relativ zu der Abbildungsoptik 52 in Richtung dreier Achsen, nämlich einer X₀-Achse, Y₀-Achse und einer Z₀-Achse zu positionieren.

Beispielsweise verläuft die Z₀-Achse parallel zur dritten Richtung Z und die X₀-Achse und die Y₀-Achse verlaufen vorzugsweise parallel zu der ersten Richtung X bzw. der zweiten Richtung Y.

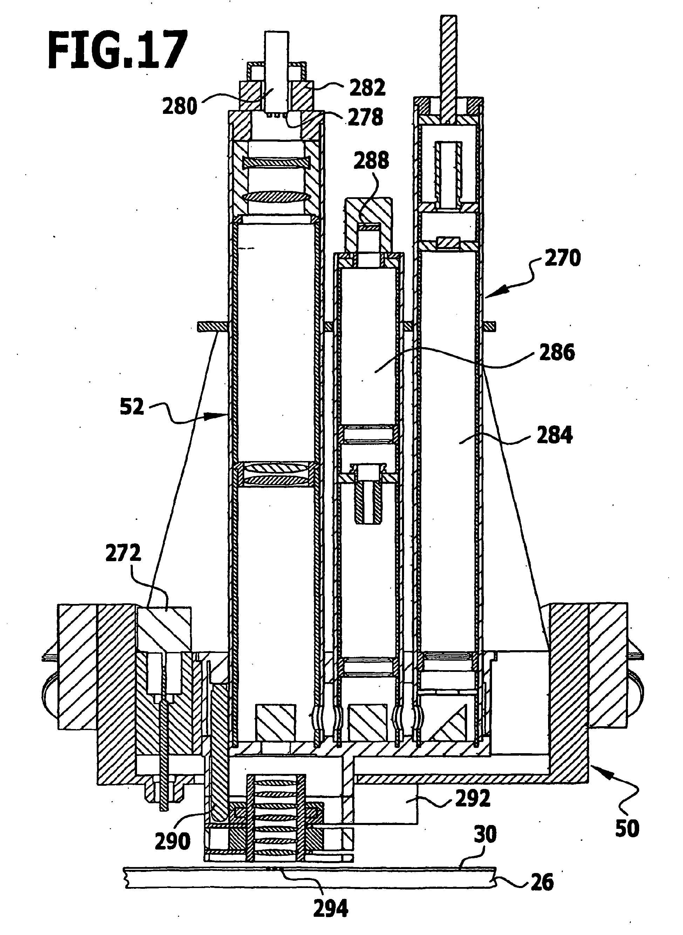

Durch die Positioniereinrichtung 282 besteht somit die Möglichkeit, die Faserenden 278 des Faserbündels relativ zur Abbildungsoptik 52 in Richtung der X₀-Achse und Y₀-Achse zu verschieben und somit auch von der Abbildungsoptik 52 durch Fokussierung erzeugte Bildflecken oder Belichtungsflecken 294 der Faserenden 278 auf der Substratoberfläche 274 in entsprechendem Umfang in der ersten Richtung X bzw. der zweiten Richtung Y zu verschieben (Fig. 17).

Es ist aber auch denkbar, mittels der Steuerung 60 die Position des Faserbündels 280 in Y₀-Richtung noch zu justieren, wenn beispielsweise mit der Quermesseinrichtung 250 eine Abweichung von einer geradlinigen Bewegung des Optikschlittens 50 erfasst wird.

Eine Verschiebung der Faserenden 278 des Faserbündels 280 mit der Positioniereinrichtung 282 in Richtung Z₀ ermöglichst ferner eine Abweichung von einem optimalen Fokus und somit eine Defokussierung, woraus gegenüber einer optimalen Fokussierung vergrößerte Belichtungsflecken 294 auf der Beschichtungsoberfläche 274 resultieren.

Darüber hinaus erlaubt die Positioniereinrichtung 282 auch noch eine Drehung des Faserbündels 280 um die Z₀-Richtung, die X₀-Richtung und die Y₀-Richtung als Drehachse, so dass ein allseitiges Verkippen des Faserbündels 280 mit den Faserenden 278 ebenfalls noch eine zusätzliche Justier- und Positioniermöglichkeit eröffnet.

Der Abbildungsoptik 52 sind zusätzlich eine Beleuchtungsoptik 284 und eine Beobachtungsoptik 286 zugeordnet, die alle mit der Abbildungsoptik 52 derart gekoppelt sind, dass eine Beleuchtung der Beschichtungsoberfläche 274 und eine Beobachtung der Beschichtungsoberfläche 274 durch die Mikroskopoptik 276 hindurch erfolgt und somit die Belichtung der Beschichtungsoberfläche 274 mit den Belichtungsflecken 294 über einen Kamerachip 288 der Beobachtungsoptik 286 durch die Mikroskopoptik 276 hindurch möglich ist.

Zur Aufrechterhaltung einer optimalen Fokussierung ist die Mikroskopoptik 276 noch über Stellelemente 290 in der dritten Richtung Z verstellbar und somit kann die optimale Fokussierung der Faserenden 278 auf die Belichtungsflecken 294 in der Beschichtungsoberfläche 274 durch ein die Stellelemente 290 ansteuerndes Autofokussystem 292 aufrechterhalten werden.

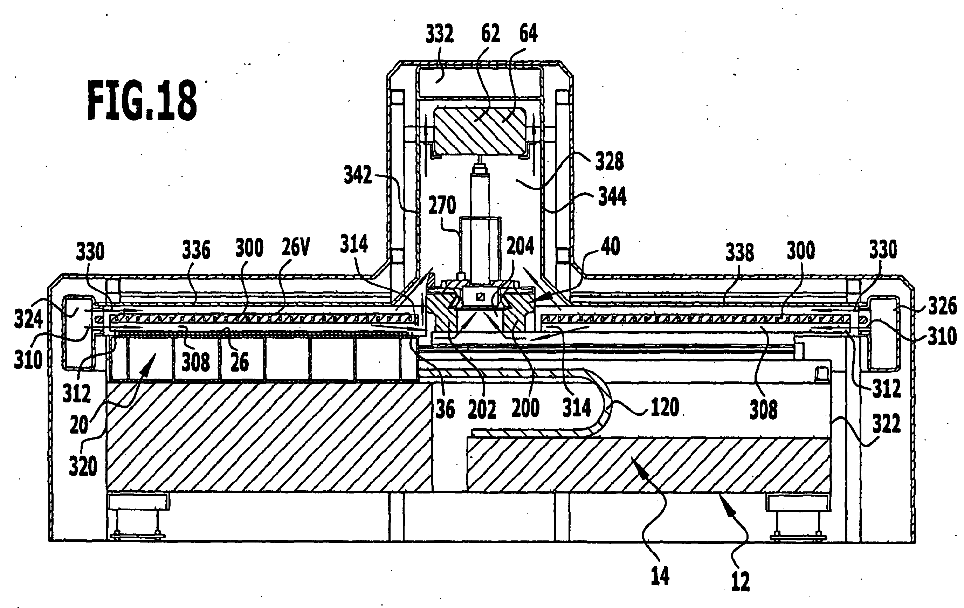

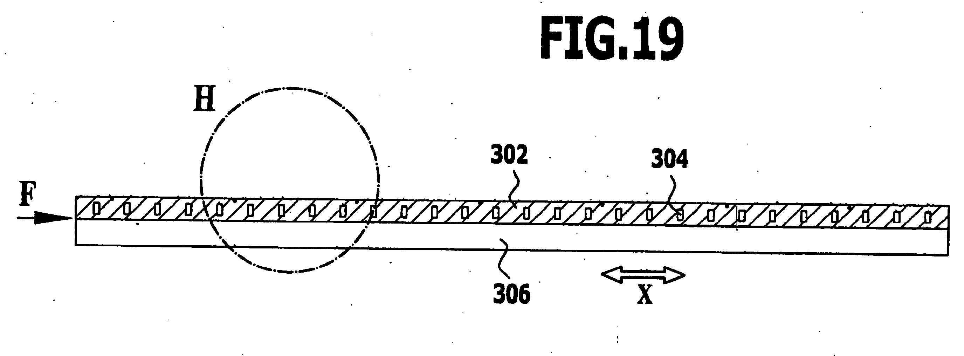

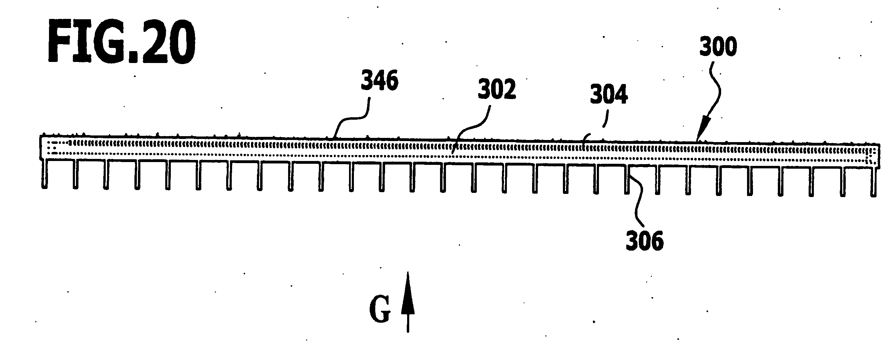

Zur Kühlung des in dem Bewegungsraum 36 mit dem Optikschlitten 20 bewegbaren Substratkörpers 26 ist auf einer dem Substratschlitten 20 gegenüberliegenden Seite des Substratkörpers 26 ein Wärmetauscherelement 300 angeordnet, welches, wie in Figur 18 bis 20 dargestellt, einen plattenförmigen Wärmetauscherkörper 302 umfasst, welcher von Kühlmittelkanälen 304 durchsetzt ist, die beispielsweise mäanderförmig durch den Wärmetauscherkörper 302 mäanderförmig, wie in Figur 20 angedeutet, hindurchverlaufen und von einem Kühlmedium, beispielsweise Kühlwasser, durchströmt sind.

Der Wärmetauscherkörper 302 ist ferner noch mit parallel zueinander verlaufenden Wärmetauscherrippen 306 versehen, die sich parallel zur ersten Richtung X und von dem Wärmetauscherkörper 302 weg in Richtung des Substratschlittens 20 erstrecken, jedoch nur so weit, dass der auf dem Substratschlitten 20 aufliegende Substratkörper 26 berührungsfrei unter den Wärmetauscherrippen 306 hindurch bewegbar ist. Das heißt, dass die Wärmetauscherrippen 306 nicht in den Bewegungsraum 36 des Substratschlittens 20 und des Substratkörpers 28 eindringen.

Die Wärmetauscherrippen 306 definieren jedoch über dem Substratschlitten 20 und dem Substratkörper 26 parallel zur ersten Richtung X verlaufende Strömungskanäle 308, durch welche, wie in Figur 18 dargestellt, ein Strom 310 eines gasförmigen Kühlmediums hindurchtritt, der einerseits über die Beschichtungsoberfläche 274 hinweg strömt und anderseits durch die Strömungskanäle 308 einerseits in der ersten Richtung X geführt ist und durch die Strömungskanäle 308 auf einer über das Wärmetauscherelement definierbaren Temperatur gehalten werden kann.

Damit hat der Strom 310 von gasförmigem Kühlmedium die Möglichkeit, auf seinem gesamten Weg über den Substratkörper 26 Wärme an die Wärmetauscherrippen 306 und den Wärmetauscherkörper 302 auf das Wärmetauscherelement 300 zu übertragen und somit seine Temperatur ausgehend von Eintrittsbereich 312 der Strömungskanäle 308 bis zu einem Austrittsbereich 314 derselben durch Wärmeaustausch beizubehalten.

Vorzugsweise sind dabei an dem Maschinengestell 12 zwei stationäre Wärmetauscherelemente 300 gehalten, die sich einerseits von einander gegenüberliegenden Enden 320 und 322 des Fundamentkörpers 14 bis zur Brücke 40 erstrecken, mit ihren Eintrittsbereichen 312 im Bereich der Enden 320 und 322 angeordnet sind und mit ihren Austrittsbereichen 314 der Brücke 40 zugewandt sind, beispielsweise im Wesentlichen an diese anschließen.

Der Strom 310 des gasförmigen Kühlmediums wird dabei von Zufuhrkanälen 324 und 326 den Eintrittsbereichen 312 der Wärmetauscherelemente 300 zugeführt.

Ferner sind die Zufuhrkanäle 324 und 326 noch so ausgebildet, dass sie zusätzlich zu dem Strom 310, der durch die Strömungskanäle 308 hindurchtritt, einen Strom 330 von gasförmigem Kühlmedium zuführen, der über das jeweilige Wärmetauscherelement 300 auf einer den Strömungskanälen 308 gegenüberliegenden Seite hinwegströmt.

Die Ströme 310 und 330 des gasförmigen Kühlmediums werden dabei im Bereich der Brücke 40 derart umgelenkt, dass beispielsweise der Strom 310 durch den Freiraum 204 zwischen den Brückenträgern 200, 202 hindurchtritt und der Strom 330 die Brückenträger 200, 202 außen umströmt, so dass die beiden Ströme 310 und 330 in einen Optikbewegungsraum 328 eintreten, in diesem zunächst die Optikeinheit 270 umströmen und kühlen und dann auch anschließend die Lichtquelleneinheit 62, die zur stärksten Erwärmung des gasförmigen Kühlmediums führt.

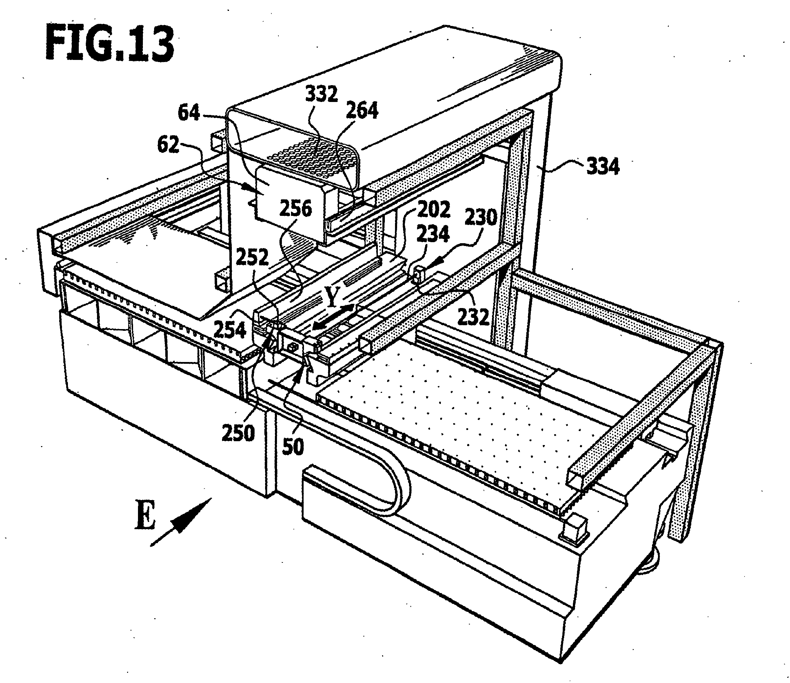

Das Kühlmedium mit den Strömen 310 und 330 wird dabei im Bereich der Optikeinheit 270 nicht weiter gekühlt, sondern erwärmt sich zusehends, insbesondere auch bei Umströmen der Lichtquelleneinheit 62, und wird durch einen Abfuhrkanal 332 zu einer beispielsweise in Figur 13 dargestellten Aufbereitungseinrichtung 334 für das gasförmige Kühlmedium geführt, die einerseits das gasförmige Kühlmedium reinigt und andererseits wiederum auf eine vorbestimmte Temperatur abkühlt, mit welcher die Aufbereitungseinrichtung 334 das gasförmige Kühlmedium wieder in die Zufuhrkanäle 324, 326 einbläst, um dieses wiederum den Wärmetauscherelementen 300 in der beschriebenen Art und Weise zuzuführen.

Wie in Figur 18 dargestellt, wird die Führung der Ströme, insbesondere des Stroms 330, noch dadurch verbessert, dass im Bereich der Wärmetauscherelemente 300 Führungswände 336, 338 vorgesehen, die insbesondere den Strom 330 des gasförmigen Kühlmediums in Richtung der Brücke 40 führen.

Ferner sind auch im Anschluss an die Brücke Führungswände 342 und 344 vorgesehen, welche die Ströme 310 und 330 im Bereich des Optikbewegungsraums 38 um die Optikeinheit 270 herum und auch um die Lichtquelleneinheit 62 herum und schließlich in den Abfuhrkanal 332 führen, so dass auch eine optimale Kühlung der Optikeinheit 270 und der Lichtquelleneinheit 62 erfolgt.

Die Wärmetauscherelemente 300 lassen sich bei der erfindungsgemäßen Lösung jedoch nicht nur dazu einsetzen, die Temperatur der Ströme 310 des gasförmigen Kühlmediums zu stabilisieren, sondern gleichzeitig dazu, noch nicht zu belichtende Substratkörper 26v auf die vorgegebene Temperatur des gasförmigen Kühlmediums zu bringen, wobei die Substratkörper 26v vorzugsweise unmittelbar auf einer den Wärmetauscherrippen 306 gegenüberliegenden Oberseite 346 der Wärmetauscherelemente 300 auflegbar sind.

Somit besteht die Möglichkeit, gleichzeitig mit der Belichtung der fotosensitiven Beschichtung 30 des auf dem Substratschlitten 20 liegenden Substratkörpers 26 ein weitere Substratkörper 26v auf die Oberseite 326 eines der Wärmetauscherelemente 300 aufzulegen und gleichzeitig während der Belichtung der fotosensitiven Beschichtung 30 auf dem Substratkörper 26 auf die Temperatur des Kühlmediums in der erfindungsgemäßen Belichtungsanlage zu bringen.

Um einen Substratkörper 26v entweder auf das Wärmetauscherelement 300 oder den Substratschlitten 20 aufbringen zu können, ist ein als Ganzes mit 350 bezeichneter Hubtisch vorgesehen, welcher seitlich des Substratschlittens 20 am Maschinengestell 20 gehalten ist und mit seiner Oberseite 352 entweder so einstellbar ist, dass diese in einer Ebene mit der Oberseite 346 des Wärmetauscherelements 300 fluchtet oder so einstellbar ist, dass die Oberseite 352 mit der Tragfläche 24 des Substratschlittens 20 fluchtet.

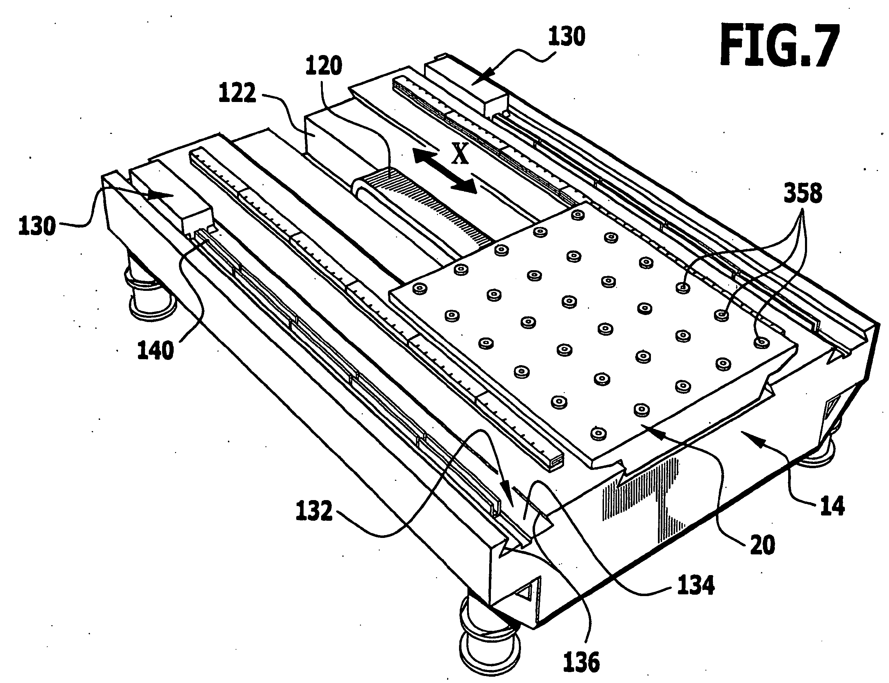

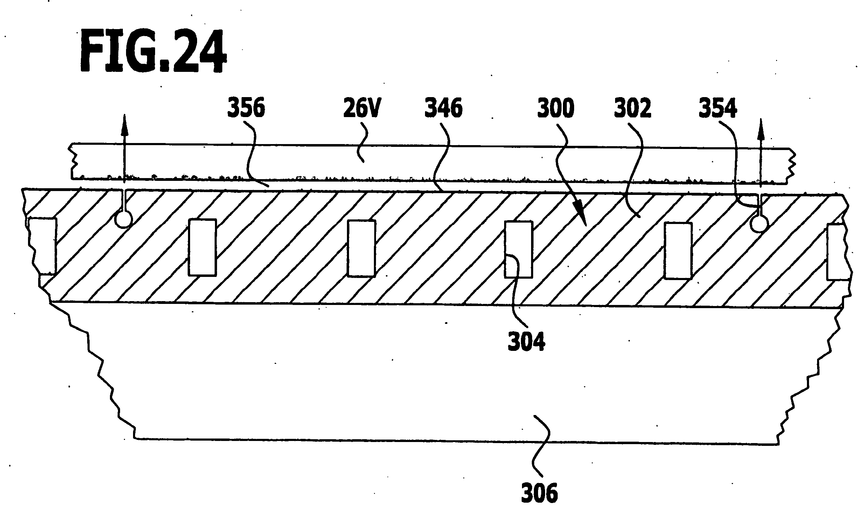

Ferner ist zum Verschieben des Substratkörpers 26 oder 26v von der Oberseite 352 des Hubtisches 350 auf das Wärmetauscherelement 300 oder die Tragfläche 24 des Substratschlittens 20, wie in Figur 24 dargestellt, die jeweiligen Oberseiten des Hubtisches 350 und des Wärmetauscherelements 300 mit Düsen 354 versehen, welches es erlauben, den Substratkörper 26 auf einem Gaspolster 356 aufschwimmen zu lassen und damit die Möglichkeit zu eröffnen, den Substratkörper auf dem Gaspolster 356 gleitend zu verschieben. Außerdem sind - wie in Fig. 7 dargestellt - auf der Tragfläche 24 des Substrattisches 20 Saug-/Blasdüsen 358 vorgesehen, die einerseits die Erzeugung eines Gaspolsters zum Verschieben des Substratkörpers 26 ermöglichen und andererseits ein Ansaugen des Substratkörpers 26 ermöglichen, um diesen auf dem Substratschlitten 20 zu fixieren.

Bei einem zweiten Ausführungsbeispiel einer erfindungsgemäßen Belichtungsanlage sind diejenigen Elemente, die mit denen des ersten Ausführungsbeispiels identisch sind, mit denselben Bezugszeichen versehen, wobei diesbezüglich auch vollinhaltlich auf das erste Ausführungsbeispiel Bezug genommen wird.

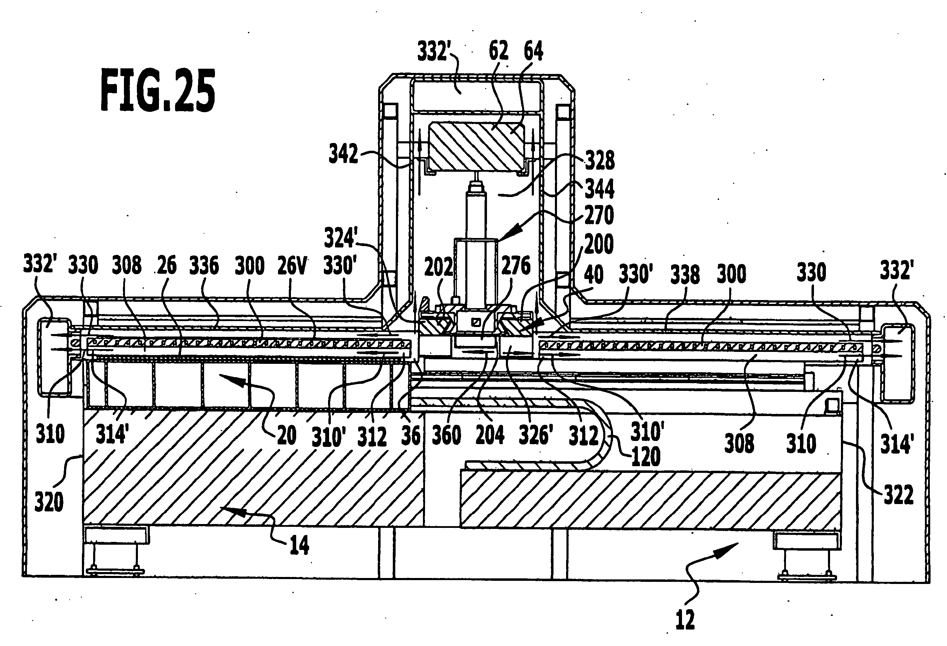

Das zweite Ausführungsbeispiel, dargestellt in Figur 25, unterscheidet sich insoweit vom ersten Ausführungsbeispiel als die Zufuhrkanäle 324', 326' im Bereich der Brücke 40, vorzugsweise unterhalb der Brückenträger 200, 202 angeordnet sind, wobei aus diesen das gasförmige Kühlmedium in Form der Ströme 310' und 330' austritt und in Richtung der Abfuhrkanäle 332' strömt, die in diesem Fall im Bereich der Enden 320 und 322 des Fundamentkörpers 14 angeordnet sind.

Somit liegen damit auch die Eintrittsbereiche 312' der Strömungskanäle 308 auf einer der Brücke 40 und den Zufuhrkanälen 324', 326' zugewandten Seite, während die Austrittsbereiche 314' der Strömungskanäle 308 den Enden 320, 322 und den Abfuhrkanälen 332' zugeordnet sind.

Ausgehend von den im Bereich der Brücke 40 angeordneten Zufuhrkanälen 324', 326' tritt das gasförmige Kühlmedium auch in der beschriebenen Weise in den Optikraum 328 ein und kühlt die Optikeinheit 270 und die Lichtquelleneinheit 62 in dem beschriebenen Umfang, wobei das gasförmige Kühlmedium nach Umströmen der Lichtquelleneinheit 62 in den weiteren über der Lichtquelleneinheit 62 angeordneten Abfuhrkanal 332' ebenfalls eintritt.

Darüber hinaus tritt vorzugsweise aus einem der Zufuhrkanäle 324', 326', beispielsweise aus dem Zufuhrkanal 326', noch gasförmiges Kühlmedium in Form eines Stroms 360 aus, welcher direkt die Abbildungsoptik im Bereich der Mikroskopoptik 276 anströmt, vorzugsweise die Mikroskopoptik 276 unterströmt, um zwischen dieser und der zu belichteten Beschichtung 30 hindurchzutreten, um die Mikroskopoptik 276 auf ihrer der Beschichtung 30 zugewandten Seite stets frei von Schmutzpartikeln zu halten.

Dieser Strom 360 von gasförmigem Kühlmedium ist somit nicht primär zur Kühlung sondern zur Sauberhaltung der der Beschichtung 30 zugewandten Mikroskopoptik 276.

Im Übrigen ist das zweite Ausführungsbeispiel in gleicher Weise ausgebildet wie das erste Ausführungsbeispiel, so dass vollinhaltlich auf die Ausführungen hierzu Bezug genommen wird.

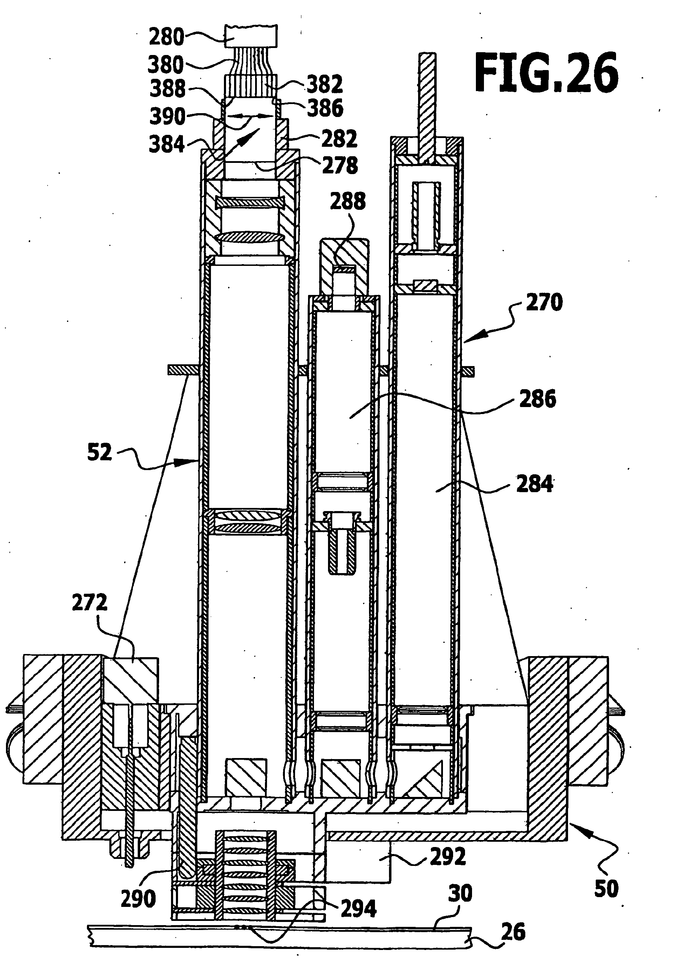

Bei einem dritten Ausführungsbeispiel einer erfindungsgemäßen Belichtungsanlage, dargestellt in Fig. 26, ist die Optikeinheit 270 im Prinzip gleich ausgebildet wie beim ersten Ausführungsbeispiel, allerdings sind endseitig des Lichtleiterbündels 280 einzelne Lichtleiter 380 herausgeführt und mit Endbereichen 382 in einer Aufnahmeeinheit 384 gehalten, und zwar so, dass die einzelnen Endflächen 386 der einzelnen Lichtleiter 380 durch die Aufnahmeeinheit 384 definiert positioniert sind und beispielsweise in einer Reihe 388 liegen, die sich in einer Richtung 390 erstreckt, welche beim dritten Ausführungsbeispiel beispielsweise parallel zur zweiten Richtung Y verläuft.

Durch die Abbildungsoptik 52, die gegebenenfalls auch noch den Endflächen 386 zugeordnete und auf der Aufnahmeeinheit 384 angeordnete Mikrolinsensysteme 53 umfasst, wird jede einzelne der Endflächen 386 in einen Belichtungsflecken 294 auf der fotosensitiven Beschichtung 30 abgebildet, so dass auf der fotosensitiven Beschichtung 30 ebenfalls eine der Reihe 388 der Endflächen 386 entsprechende Reihe von Belichtungsflecken 294 erzeugbar ist.

Im Übrigen ist das dritte Ausführungsbeispiel der erfindungsgemäßen Belichtungsanlage in gleicher Weise ausgebildet wie das erste und das zweite Ausführungsbeispiel, so dass diesbezüglich vollinhaltlich auf die Ausführungen zu diesen Ausführungsbeispielen Bezug genommen werden kann.

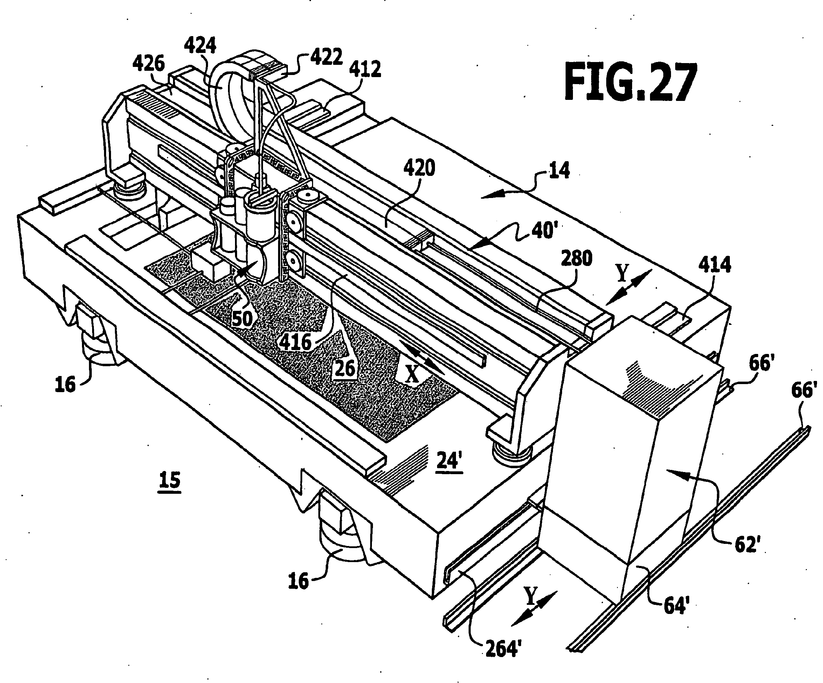

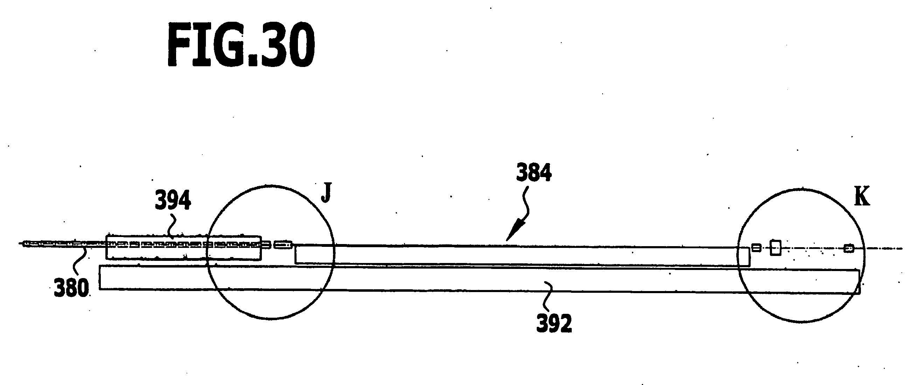

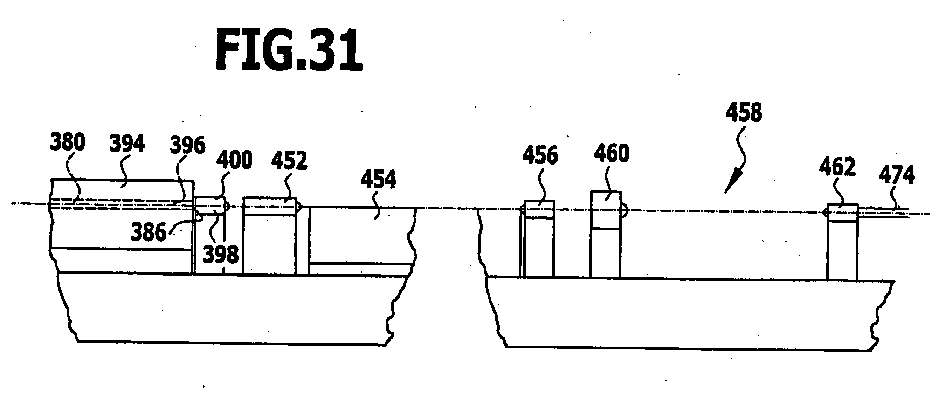

Bei einem vierten Ausführungsbeispiel der erfindungsgemäßen Belichtungsanlage, dargestellt in den Fig. 27 bis 31, ist ebenfalls der Fundamentkörper 14 vorgesehen, der seinerseits die fest auf diesem angeordnete Tragfläche 24 trägt, auf welcher der als Ganzes mit 26 bezeichnete Substratkörper auflegbar ist.

Im Gegensatz zum ersten Ausführungsbeispiel ist außerdem die als Ganzes mit 40' bezeichnete Brücke relativ zu dem Fundamentkörper 14 mittels zweier Linearmotoren 412 und 414 parallel zur zweiten Richtung Y bewegbar, während der als Ganzes mit 50 bezeichnete Optikschlitten längs der Brücke 40' parallel zur ersten Richtung X bewegbar ist und hierzu durch einen Linearmotor 416 antreibbar ist.

Bei dem vierten Ausführungsbeispiel ist die Lichtquelleneinheit 62' seitlich neben dem Fundamentkörper 414 angeordnet und sitzt auf einem Lichtquellenschlitten 64', der seinerseits an Schlittenführungen 66' geführt ist, und längs dieser bewegbar ist, wobei sich bei dem dargestellten Ausführungsbeispiel sich die Schlittenführungen 66' parallel zu der zweiten Richtung Y erstrecken, allerdings in diesem Fall auf derselben Standfläche 15 abgestützt ist, wie die schwingungsdämpfenden Stützen 16.

Der Optikschlitten 64' ist ferner durch den Linearantrieb 264' in der zweiten Richtung Y bewegbar, wobei in diesem Fall der Linearantrieb 264' einerseits an dem Fundamentkörper 14 und andererseits an dem Lichtquellenschlitten 64' angreift.

Vorzugsweise ist der Lichtquellenschlitten 64' bei dem vierten Ausführungsbeispiel derart bewegbar, dass dieser den Bewegungen der Brücke 40' in der zweiten Richtung Y im Wesentlichen folgt, wobei allerdings eine Grobpositionierung insoweit ausreichend ist, als zwischen der Lichtquelleneinheit 62' und der Optikeinheit 270 die Strahlung durch das flexible Faserbündel 280 übertragen wird, das bei dem vierten Ausführungsbeispiel auf einer Oberseite der Brücke 40' aufliegt und über eine flexible Schleppkette 420, die bogenförmig, zu dem Optikschlitten 50 verläuft, geführt ist.

Dabei erstreckt sich die Schleppkette 420 ausgehend von einem am Optikschlitten 50 vorgesehenen Halter 422 in einem Bogen 424 zu einer an der Brücke 40 vorgesehenen Aufnahme 426, in welche je nach Stellung des Optikschlittens 50 ein mehr oder weniger größerer Abschnitt der Schleppkette 420 einlegbar ist.

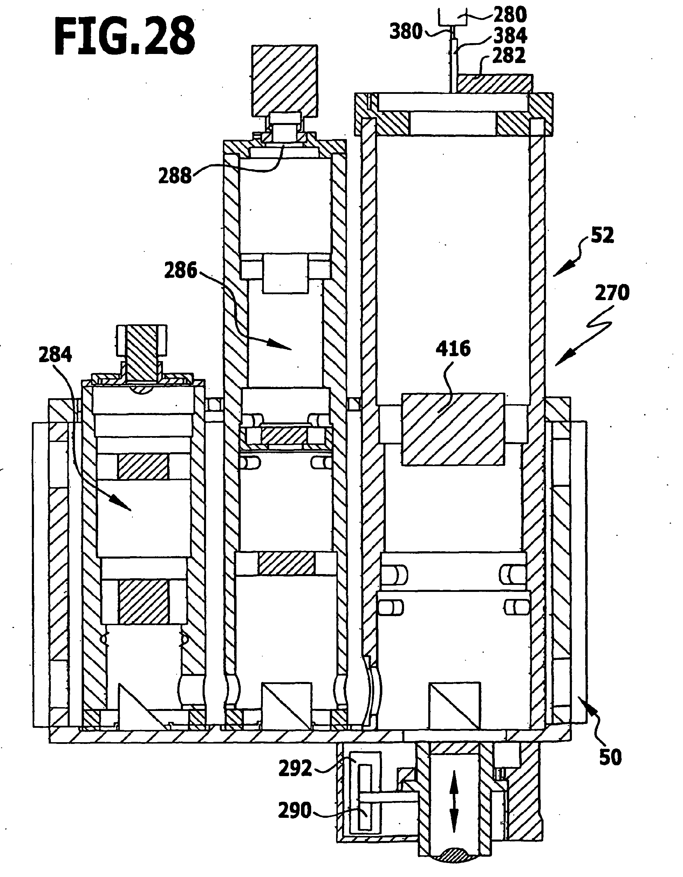

Wie in Fig. 28 dargestellt, ist die Optikeinheit 270 im Prinzip in gleicher Weise aufgebaut wie beim ersten und dritten Ausführungsbeispiel, so dass für dieselben Elemente dieselben Bezugszeichen verwendet sind und somit auch vollinhaltlich auf die Ausführungen zum ersten, zweiten und dritten Ausführungsbeispiel Bezug genommen wird.

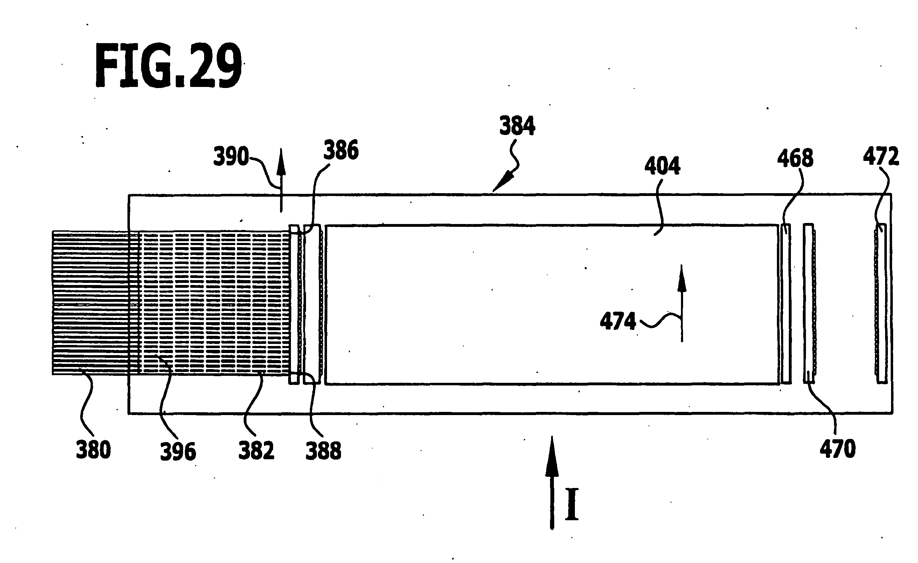

Dabei sind in gleicher Weise wie beim dritten Ausführungsbeispiel die einzelnen aus dem Faserbündel 280 herausgeführten Lichtleiter 380 mit ihren Endbereichen 382 in der Aufnahmeeinheit 384 gehalten, so dass die Endflächen 386 der einzelnen Lichtleiter 380 ebenfalls in der Reihe 388 liegen, die sich in der Richtung 390 erstreckt, wobei die Richtung 390 vorzugsweise parallel zur zweiten Richtung Y verläuft (Fig. 29 bis 31).

Vorzugsweise umfasst die Aufnahmeeinheit 384 eine Basis 392, auf welcher eine Aufnahmeplatte 394 angeordnet ist, welche eine Vielzahl von Vertiefungen, beispielsweise Rillen, 396 aufweist, in welchen die Endbereiche 382 der einzelnen Lichtleiter 380 einlegbar und somit in die Aufnahmeplatte 394 fixierbar sind.

Aus den einzelnen Endflächen 386 tritt ein divergentes Strahlungsfeld aus, welches vorzugsweise jeweils durch eine Kollimationslinse 398 zu einem kollimierten Strahlungsfeld umgeformt wird, wobei jeder einzelnen Endfläche 386 eine Kollimationslinse 398 zugeordnet ist und die Gesamtheit der Kollimationslinsen 398 in einem Kollimationslinsenarray 400 sitzt.

Jedes von einer Kollimationslinse 398 kollimierte Strahlungsfeld erfährt nachfolgend durch eine Zylinderoptik 452 eine Einkopplung in einen Wellenleiter 454, der beispielsweise als Schichtwellenleiter ausgebildet ist, und tritt aus diesem wieder aus, wobei eine weitere Zylinderoptik 456 vorgesehen ist, welche wieder ein kollimiertes Strahlungsfeld bildet, das dann durch eine Teleskopoptik 458, umfassend die optischen Elemente 460 und 462 zu einem austretenden kollimierten Strahlungsfeld 464 geformt wird, welches dann in ein Tubussystem 466, dargestellt in Figur 28, eintritt.

Die einzelnen Zylinderoptiken 452 und 456 sind ebenfalls zu Zylinderoptikarrays 467 und 468 zusammengefasst und in gleicher Weise sind die optischen Elemente 460 und 462 der Teleskopoptik 458 zu Arrays 470 und 472 zusammengefasst.

Der Wellenleiter 454 ist insbesondere noch als elektrooptische Ablenkeinheit ausgebildet, durch welche eine Ablenkung der aus jeder der Endflächen 386 austretenden Strahlung in einer Richtung 474 erfolgen kann, welche vorzugsweise parallel zur Richtung 390 und insbesondere ebenfalls parallel zur zweiten Richtung Y verläuft.

Eine Ablenkung der aus jeder der einzelnen Endflächen 386 austretenden Strahlung ermöglicht es somit auch die Belichtungsflecken 294 in der Richtung 474 zu verschieben und ausgehend von einer Reihe von Belichtungsflecken 294 bei nicht aktiver Ablenkeinheit in den zwischen diesen Belichtungsflecken vorliegenden Zwischenräumen ebenfalls die fotosensitive Beschichtung 30 durch Ablenken einzelner Belichtungsflecken 294 zu belichten.

Bei einer vereinfachten Ausführung des vierten Beispiels wird auf die Ablenkbarkeit der aus den Endflächen 386 austretenden Strahlung verzichtet, so dass die Zylinderoptiken 452 und 456 sowie der Wellenleiter 454 entfallen können.

## Patentansprüche

1. Belichtungsanlage für Substratkörper (26), die auf einer Substratoberfläche (28) eine fotosensitive Beschichtung (30) tragen, umfassend ein Maschinengestell (12), einen den Substratkörper (26) tragenden Substratträger (20), und eine Belichtungseinrichtung (54), wobei der Substratkörper (26) und die Belichtungseinrichtung (54) relativ zueinander in einer zu einer Substratoberfläche (28) parallelen ersten Richtung (X) und in einer zur Substratoberfläche (28) parallelen zweiten und quer zur ersten Richtung (X) verlaufenden Richtung (Y) bewegbar sind, so dass durch diese Relativbewegung der Belichtungseinrichtung (54) zur fotosensitiven Beschichtung (30) in der ersten Richtung (X) und in der zweiten Richtung (Y) die fotosensitive Beschichtung (30) lokal selektiv durch von der Belichtungseinrichtung (54) erzeugbare Belichtungsflecken (294) belichtbar ist, wobei die Belichtungseinrichtung (54) einen in der zweiten Richtung (Y) bewegbaren Optikschlitten (50) aufweist, auf dem eine Abbildungsoptik (52) für die Belichtung des Substratkörpers (26) angeordnet ist, und wobei die Belichtungseinrichtung (54) eine an dem Maschinengestell (12) getrennt von dem Optikschlitten (50) angeordnete Lichtquelleneinheit (62) aufweist, deren Strahlung in die Abbildungsoptik (52) einkoppelbar ist, und eine Steuerung (60)
**dadurch gekennzeichnet, dass** die Lichtquelleneinheit (62) eine Vielzahl von Lichtquellen (61) aufweist, dass mindestens ein flexibles Lichtleiterbündel (280) von der Lichtquelleneinheit (62) zu der von einer Optikeinheit (270) umfassten Abbildungsoptik (52) geführt ist, und dass ein Ende (386) des Lichtleiterbündels (280) durch die Steuerung (60) mittels einer einstellbaren Positioniereinrichtung (282) relativ zur Abbildungsoptik (52) positionierbar ist.

2. Belichtungsanlage nach Anspruch 1, **dadurch gekennzeichnet, dass** die Lichtquelleneinheit (62) der Belichtungseinrichtung (54) getrennt von einer den Optikschlitten (50) führenden Brücke (40) angeordnet ist.

3. Belichtungsanlage nach Anspruch 2, **dadurch gekennzeichnet, dass** die Lichtquelleneinheit (62) auf einer Seite der Brücke (40) angeordnet ist.

4. Belichtungsanlage nach einem der Ansprüche 1 bis 3, **dadurch gekennzeichnet, dass** die Lichtquelleneinheit (62) mit der Optikeinheit (270) in der zweiten Richtung (Y) bewegbar ist.

5. Belichtungsanlage nach Anspruch 4, **dadurch gekennzeichnet, dass** die Lichtquelleneinheit (62) auf separaten für diese vorgesehenen Führungen (66) geführt ist.

6. Belichtungsanlage nach Anspruch 4 oder 5, **dadurch gekennzeichnet, dass** die Lichtquelleneinheit (62) in der zweiten Richtung (Y) durch einen Linearantrieb (264) bewegbar ist.

7. Belichtungsanlage nach einem der voranstehenden Ansprüche, **dadurch gekennzeichnet, dass** die Belichtungseinrichtung (54) einen in der zweiten Richtung (Y) bewegbaren Lichtquellenschlitten (64) aufweist, auf dem die Lichtquelleneinheit (62) angeordnet ist.

8. Belichtungsanlage nach Anspruch 7, **dadurch gekennzeichnet, dass** der Lichtquellenschlitten (64) so angetrieben ist, dass er den Bewegungen des Optikschlittens (50) im Wesentlichen folgt.

9. Belichtungsanlage nach einem der voranstehenden Ansprüche, **dadurch gekennzeichnet, dass** die Lichtquelleneinheit (62) auf außerhalb des Maschinengestells (12) angeordneten Führungen (66') bewegbar ist.

10. Belichtungsanlage nach Anspruch 9, **dadurch gekennzeichnet, dass** die Lichtqueileneinheit (62) seitlich neben einer Stirnseite der Brücke (40) angeordnet ist.

11. Belichtungsanlage nach einem der voranstehenden Ansprüche, **dadurch gekennzeichnet, dass** das flexible Lichtleiterbündel (280) in einer an der Brücke (40') vorgesehenen und zum Optikschlitten (50) führenden Schleppführung (420) geführt ist.

12. Belichtungsanlage nach Anspruch 11, **dadurch gekennzeichnet, dass** die Schleppführung (420) in einer an der Brücke (40') vorgesehenen Aufnahme (426) verläuft.

13. Belichtungsanlage nach Anspruch 12, **dadurch gekennzeichnet, dass** die Aufnahme (426) als ein in der Brücke (40') vorgesehener Kanal ausgebildet ist.

14. Belichtungsanlage nach einem der voranstehenden Ansprüche, **dadurch gekennzeichnet, dass** die Positioniereinrichtung (282) so ausgebildet ist, dass sie es erlaubt, mindestens einen von der Abbildungsoptik (52) erzeugten Selichtungsfleck (294) auf der fotosensitiven Beschichtung (30) In mindestens einer zu einer Beschichtungsoberfläche parallelen Richtung (X, Y) zu verschieben.

15. Belichtungsanlage nach Anspruch 14, **dadurch gekennzeichnet, dass** die Positioniereinrichtung (282) so ausgebildet ist, dass sie es erlaubt, den mindestens einen von der Abbildungsoptik (52) erzeugten Belichtungsfleck (294) auf der fotosensitiven Beschichtung (30) in zwei zur Beschichtungsoberfläche (274) parallelen, quer zueinander verlaufenden Richtungen (X, Y) zu verschieben.

16. Belichtungsanlage nach einem der voranstehenden Ansprüche, **dadurch gekennzeichnet, dass** mit der Positioniereinrichtung (282) das Ende des Lichtleiterbündels (280) relativ zur Abbildungsoptik (52) derart bewegbar ist, dass ein Durchmesser des mindestens einen auf der fotosensitiven Beschichtung erzeugbaren Belichtungsflecks variierbar ist.

17. Belichtungsanlage nach einem der voranstehenden Ansprüche, **dadurch gekennzeichnet, dass** mit der Positioniereinrichtung (282) eine Aufnahmeeinheit (384) für das Lichtleiterbündel (280) relativ zur Abbildungsoptik (52) derart bewegbar ist, dass ein Durchmesser des mindestens einen auf der fotosensitiven Beschichtung (30) erzeugbaren Belichtungsflecks (294) variierbar ist.

18. Belichtungsanlage nach einem der voranstehenden Ansprüche, **dadurch gekennzeichnet, dass** die Abbildungsoptik (52) mit einem Autofokussystem (292) versehen ist.

19. Belichtungsanlage nach einem der voranstehenden Ansprüche, **dadurch gekennzeichnet, dass** die Positioniereinrichtung (282) einen Piezoantrieb als Stellantrieb umfasst.

20. Belichtungsanlage nach einem der voranstehenden Ansprüche, **dadurch gekennzeichnet, dass** der Optikschlitten (50) eine die Abbildungsoptik (52) umfassende Optikeinheit (270) trägt, die relativ zum Optikschlitten (50) bewegbar ist.

21. Belichtungsanlage nach Anspruch 20, **dadurch gekennzeichnet, dass** die Optikeinheit (270) relativ zum Optikschlitten (50) in einer dritten, quer zur ersten und zweiten Richtung (X, Y) verlaufenden Richtung (Z) bewegbar ist.

22. Belichtungsanlage nach einem der voranstehenden Ansprüche, **dadurch gekennzeichnet, dass** die Optikeinheit (270) eine mit der Abbildungsoptik (52) gekoppelte Beobachtungsoptik (286) umfasst.

23. Belichtungsanlage nach Anspruch 22, **dadurch gekennzeichnet, dass** die Beobachtungsoptik (286) mit einer Beleuchtungsoptik (284) versehen ist.

24. Belichtungsanlage nach einem der voranstehenden Ansprüche, **dadurch gekennzeichnet, dass** der Optikschlitten (50) an einer über einem Bewegungsraum (36) von Substratschlitten und Substratkörper verlaufenden Führung (40) am Maschinengestell (12) geführt ist.

25. Belichtungsanlage nach einem der voranstehenden Ansprüche, **dadurch gekennzeichnet, dass** ein Längsmesssystem (230) vorgesehen ist, das beim Bewegen des Optikschlittens (50) ständig die Position des Optikschlittens (50) in der zweiten Richtung (Y) erfasst.

26. Belichtungsanlage nach einem der voranstehenden Ansprüche, **dadurch gekennzeichnet, dass** ein Quermesssystem (250) vorgesehen ist, das beim Bewegen des Optikschlittens (50) ständig die Position des Optikschlittens (50) quer zur zweiten Richtung (Y) erfasst.

27. Belichtungsanlage nach Anspruch 25 oder 26, **dadurch gekennzeichnet, dass** das Längsmesssystem (230) und/oder das Quermesssystem (250) optische Messeinrichtungen sind.

28. Belichtungsanlage nach Anspruch 27, **dadurch gekennzeichnet, dass** die optischen Messeinrichtungen (230, 250) einen Lichtweg interferometrisch erfassen.

29. Belichtungsanlage nach einem der voranstehenden Ansprüche, **dadurch gekennzeichnet, dass** das Maschinengestell (12) ein Fundament (14) aufweist, an dem als Substratträger ein Substratschlitten (20) in der ersten Richtung (X) bewegbar geführt ist.

30. Belichtungsanlage nach Anspruch 29, **dadurch gekennzeichnet, dass** das Fundament (14) auf schwingungsdämpfenden Stützen (16) angeordnet ist.

31. Belichtungsanlage nach Anspruch 29 oder 30, **dadurch gekennzeichnet, dass** das Maschinengestell (12) eine sich quer zur ersten Richtung (X) erstreckende Brücke (40) aufweist, an welcher ein Optikschlitten der Belichtungseinrichtung geführt ist.

32. Belichtungsanlage nach Anspruch 31, **dadurch gekennzeichnet, dass** die Brücke (40) auf dem Fundament (14) angeordnet ist.

33. Belichtungsanlage nach Anspruch 31 oder 32, **dadurch gekennzeichnet, dass** der Substrattisch (20) relativ zu der Brücke (40) derart bewegbar ist, dass der Substrattisch (20) nur auf einer Seite der Brücke (40) vollständig unter der Brücke (40) herausfahrbar ist.

34. Belichtungsanlage nach einem der voranstehenden Ansprüche, **dadurch gekennzeichnet, dass** der Substratschlitten (20) durch mindestens einen elektrischen Linearantrieb in der ersten Richtung bewegbar ist.

35. Belichtungsanlage nach Anspruch 34, **dadurch gekennzeichnet, dass** der Substrattisch (20) durch zwei im Abstand voneinander angeordnete Linearantriebe (90) in der ersten Richtung (X) bewegbar ist.

36. Belichtungsanlage nach einem der voranstehenden Ansprüche, **dadurch gekennzeichnet, dass** ein als Substratträger ausgebildeter Substratschlitten (20) als Tragwerkstruktur (100) aufgebaut ist.

37. Belichtungsanlage nach Anspruch 36, **dadurch gekennzeichnet, dass** die Tragwerkstruktur (100) des Substratschlittens (20) mindestens eine Flächenstruktur (102, 104) und quer zur Flächenstruktur (102, 104) eine Versteifungsstruktur (108) aus quer zur Flächenstruktur (102, 104) verlaufenden Versteifungswänden (106) aufweist.

38. Belichtungsanlage nach Anspruch 37, **dadurch gekennzeichnet, dass** die Flächenstruktur als obere und/oder untere Wand (102, 104) des Substratschlittens (20) ausgebildet ist.

39. Belichtungsanlage nach Anspruch 37 oder 38, **dadurch gekennzeichnet, dass** mehrere Versteifungswände (106) vorgesehen sind, die miteinander verbunden sind und eine zusammenhängende Gitterstruktur bilden, die mit der Flächenstruktur (102, 104) verbunden ist.

40. Belichtungsanlage nach einem der voranstehenden Ansprüche, **dadurch gekennzeichnet, dass** der Substratschlitten (20) aus einem Leichtbaumaterial hergestellt ist.

41. Belichtungsanlage nach Anspruch 40, **dadurch gekennzeichnet, dass** das Leichtbaumaterial ein faserverstärktes Material ist.

42. Belichtungsanlage nach Anspruch 40 oder 41, **dadurch gekennzeichnet, dass** der Substratschlitten (20) aus C/SiC-Material hergestellt ist.

43. Belichtungsanlage nach einem der voranstehenden Ansprüche, **dadurch gekennzeichnet, dass** direkt am Substratschlitten (20) ein Läufer des mindestens einen Linearantriebs (90) angeordnet ist.

44. Belichtungsanlage nach Anspruch 43, **dadurch gekennzeichnet, dass** der mindestens eine Läufer (94) im Bereich eines zur Montage desselben vorgesehenen Fußes (114) gekühlt ist.

45. Belichtungsanlage nach Anspruch 44, **dadurch gekennzeichnet, dass** der Fuß (114) des mindestens einen Läufers (94) mit Kühlkanälen (118) durchsetzt ist.

46. Belichtungsanlage nach einem der voranstehenden Ansprüche, **dadurch gekennzeichnet, dass** mindestens ein Impulsausgleichsschlitten (130) vorgesehen ist, welcher im Wesentlichen gegenläufig zum Substratschlitten (20) bewegbar ist.

47. Belichtungsanlage nach Anspruch 46, **dadurch gekennzeichnet, dass** der Substratschlitten (20) zwischen zwei gegenläufig zu diesem bewegbaren Impulsausgleichsschlitten (130) angeordnet ist.

48. Belichtungsanlage nach Anspruch 46 oder 47, **dadurch gekennzeichnet, dass** der mindestens eine Impulsausgleichsschlitten durch einen elektrischen Linearantrieb angetrieben ist.

49. Belichtungsanlage nach einem der Ansprüche 46 bis 48, **dadurch gekennzeichnet, dass** der mindestens eine Impulsausgleichsschlitten (130) elektronisch gegenläufig mit dem Substratschlitten (20) gekoppelt ist.

50. Belichtungsanlage nach einem der Ansprüche 46 bis 49, **dadurch gekennzeichnet, dass** ein Massenschwerpunkt (150) des Substratschlittens (20) und ein Massenschwerpunkt (152) des mindestens einen Impulsausgleichsschlittens (130) in einer gemeinsamen Ebene (154) angeordnet sind.

51. Belichtungsanlage nach einem der voranstehenden Ansprüche, **dadurch gekennzeichnet, dass** ein Längsmesssystem (160) vorgesehen ist, welches beim Bewegen des Substratschlittens (20) ständig die Position des Substratschlittens (20) in der ersten Richtung (X) erfasst.

52. Belichtungsanlage nach einem der voranstehenden Ansprüche, **dadurch gekennzeichnet, dass** ein Quermesssystem (180) vorgesehen ist, welches beim Bewegen des Substratschlittens (20) ständig die Position des Substratschlittens (20) quer zur ersten Richtung (X) erfasst.

53. Belichtungsanlage nach Anspruch 51 oder 52, **dadurch gekennzeichnet, dass** das Längsmesssystem (160) und das Quermesssystem (180) als optische Messsysteme ausgebildet sind.

54. Belichtungsanlage nach Anspruch 53, **dadurch gekennzeichnet, dass** das optische Messsystem eine interferometrische Längenmessung vornimmt.

55. Belichtungsanlage nach einem der voranstehenden Ansprüche, **dadurch gekennzeichnet, dass** über einem Bewegungsraum (36) eines als Substratträger ausgebildeten Substratschlittens (20) und des Substratkörpers (26) mindestens ein Wärmetauscherelement (300) angeordnet ist, welches einem in dem Bewegungsraum (36) vorliegenden gasförmigen Kühlmediums Wärme entzieht.

56. Belichtungsanlage nach Anspruch 55, **dadurch gekennzeichnet, dass** beidseitig im Anschluss an die Brücke (40) über dem Bewegungsraum (36) Wärmetauscherelemente (300) vorgesehen sind.

57. Belichtungsanlage nach Anspruch 55 oder 56, **dadurch gekennzeichnet, dass** das Wärmetauscherelement (300) sich in Richtung des Bewegungsraums (36) erstreckende Wärmetauscherflächen (306) aufweist.

58. Belichtungsanlage nach Anspruch 57, **dadurch gekennzeichnet, dass** die Wärmetauscherflächen (306) parallel zu einer vorgegebenen Richtung (X) verlaufen.

59. Belichtungsanlage nach Anspruch 58, **dadurch gekennzeichnet, dass** die vorgegebene Richtung die erste Richtung (X) ist.

60. Belichtungsanlage nach einem der Ansprüche 48 bis 59 **dadurch gekennzeichnet, dass** die Wärmetauscherflächen (306) so angeordnet sind, dass sich ein Strömungskanal (308) ergibt, der in der vorgegebenen Richtung (X) verläuft.

61. Belichtungsanlage nach einem der Ansprüche 55 bis 60, **dadurch gekennzeichnet, dass** das Wärmetauscherelement (300) dazu vorgesehen ist, einen weiteren Substratkörper (26V) zu temperieren.

62. Belichtungsanlage nach Anspruch 61, **dadurch gekennzeichnet, dass** das Wärmetauscherelement (300) durch körperlichen Kontakt mit dem zu temperierenden Substratkörper (26V) wechselwirkt.

63. Belichtungsanlage nach Anspruch 61 oder 62, **dadurch gekennzeichnet, dass** das Wärmetauscherelement (300) als Träger für den zu temperierenden Substratkörper (26V) ausgebildet ist.

64. Belichtungsanlage nach Anspruch 62 oder 63, **dadurch gekennzeichnet, dass** der Substratkörper (26) flächenhaft auf dem Wärmetauscherelement aufliegt.

65. Belichtungsanlage nach einem der voranstehenden Ansprüche, **dadurch gekennzeichnet, dass** der Bewegungsraum (36) des Substratschlittens (20) und des Substratkörpers (26) von einem Strom eines temperaturstabilisierten gasförmigen Kühlmediums durchsetzt ist.

66. Belichtungsanlage nach Anspruch 65, **dadurch gekennzeichnet, dass** der Strom (310) des gasförmigen Kühlmediums eine Beschichtungsoberfläche (274) der fotosensitiven Beschichtung (30) überstreicht.

67. Belichtungsanlage nach Anspruch 65 oder 66, **dadurch gekennzeichnet, dass** der Strom (310) des gasförmigen Kühlmediums von einem Zufuhrkanal (324, 326) zu einem Abfuhrkanal (332) verläuft.

68. Belichtungsanlage nach Anspruch 67, **dadurch gekennzeichnet, dass** der Strom (310) des gasförmigen Kühlmediums längs des Bewegungsraums (36) ungefähr parallel zur ersten Richtung (X) verläuft.

69. Belichtungsanlage nach Anspruch 67 oder 68, **dadurch gekennzeichnet, dass** jeweils ein Zufuhrkanal (324, 326) in einem der Brücke (40) gegenüberliegenden Endbereich des Maschinengestells (12) angeordnet ist.

70. Belichtungsanlage nach Anspruch 67 oder 68, **dadurch gekennzeichnet, dass** mindestens ein Zufuhrkanal (324', 326') im Bereich der Brücke (40) angeordnet ist.

71. Belichtungsanlage nach einem der Ansprüche 67 bis 68, **dadurch gekennzeichnet, dass** der Abfuhrkanal (332) im Bereich über der Brücke (40) angeordnet ist.

72. Belichtungsanlage nach einem der Ansprüche 67 bis 71, **dadurch gekennzeichnet, dass** der Strom (310, 330) des gasförmigen Kühl-mediums durch einen über der Brücke (40) angeordneten Optikbewegungsraum (328) geführt ist.

73. Belichtungsanlage nach Anspruch 72, **dadurch gekennzeichnet, dass** der Strom (310, 330) des gasförmigen Kühlmediums in dem Optikbewegungsraum (328) zunächst den Optikschlitten (50) mit der Abbildungsoptik (52) und dann die Lichtquelleneinheit (62) umströmt.

74. Belichtungsanlage nach einem der Ansprüche 67 bis 73, **dadurch gekennzeichnet, dass** der Strom des gasförmigen Kühlmediums nach Abfuhr desselben durch den Abfuhrkanal (332) einer Aufbereitungseinrichtung (334) zugeführt wird.

75. Belichtungsanlage nach einem der Ansprüche 65 bis 74, **dadurch gekennzeichnet, dass** ein Strom (330) des gasförmigen Kühlmediums auf einer dem Substratkörper (26) auf dem Substratschlitten (20) zugewandten Seite des Wärmetauscherelements (300) entlangströmt.

76. Belichtungsanlage nach Anspruch 75, **dadurch gekennzeichnet, dass** der Strom (310) des gasförmigen Kühlmediums durch auf dieser Seite des Wärmetauscherelements (300) angeordnete und durch die Wärmetauscherrippen (306) gebildeten Strömungskanäle (308) strömt.

77. Belichtungsanlage nach einem der Ansprüche 65 bis 76, **dadurch gekennzeichnet, dass** der auf dem Wärmetauscherelement (300) angeordnete zu temperierende Substratkörper (26V) von einem Strom (330) des gasförmigen Kühlmediums auf einer dem Substratschlitten (20) abgewandten Seite überströmt ist.

78. Belichtungsanlage nach einem der Ansprüche 65 bis 77, **dadurch gekennzeichnet, dass** das gasförmige Kühlmedium die Abbildungsoptik (52) auf ihrer der Beschichtung (30) zugewandten Seite unterströmt.

79. Belichtungsanlage nach einem der voranstehenden Ansprüche, **dadurch gekennzeichnet, dass** ein Substratbeschickungstisch (350) vorgesehen ist, über welchen Substratkörper (26, 26V) der Belichtungsanlage zuführbar sind.

80. Belichtungsanlage nach Anspruch 79, **dadurch gekennzeichnet, dass** der Substratbeschickungstisch (350) höhenverstellbar angeordnet ist.

81. Belichtungsanlage nach Anspruch 80, **dadurch gekennzeichnet, dass** der Substratbeschickungstisch (350) derart einstellbar ist, dass der Substratkörper (26, 26V) ohne Höhenversatz in jeweils einer Ebene zwischen dem Substratbeschickungstisch (350) und dem Substratschlitten (20) oder dem Substratbeschickungstisch (350) und dem Wärmetauscherelement (300) verschiebbar ist.

82. Belichtungsanlage nach einem der Ansprüche 79 bis 81, **dadurch gekennzeichnet, dass** der Substratbeschickungstisch (350) und der Substratschlitten (20) oder der Substratbeschickungstisch (350) und das Wärmetauscherelement (300) mit Einrichtungen (354, 358) zur Erzeugung eines Luftpolsters versehen sind.

83. Belichtungsanlage nach einem der voranstehenden Ansprüche, **dadurch gekennzeichnet, dass** der Substratkörper (26) auf dem Substratschlitten (20) durch Ansaugelemente (358) fixierbar ist.

## Claims

1. Exposure apparatus for substrate members (26) bearing a photosensitive coating (30) on a substrate surface (28), comprising a machine frame (12), a substrate carrier (20) bearing the substrate member (26) and an exposure device (54), wherein the substrate member (26) and the exposure device (54) are movable relative to one another in a first direction (X) parallel to a substrate surface (28) and in a second direction (Y) parallel to the substrate surface (28) and extending transversely to the first direction (X) such that the photosensitive coating (30) is exposable locally and selectively by exposure spots (294) generatable by the exposure device (54) as a result of this relative movement of the exposure device (54) in relation to the photosensitive coating (30) in the first direction (X) and in the second direction (Y), wherein the exposure device (54) has an optics slide (50) movable in the second direction (Y), an optical imaging device (52) for the exposure of the substrate member (26) being arranged on said slide, and wherein the exposure device (54) has a light source unit (62) arranged on the machine frame (12) separately from the optics slide (50), the radiation of said light source unit being couplable into the optical imaging device (52), and a control (60), **characterized in that** the light source unit (62) has a plurality of light sources (61), that at least one flexible bundle of light guides (280) is guided from the light source unit (62) to the optical imaging device (52) comprised by an optics unit (270) and that one end (386) of the bundle of light guides (280) is positionable relative to the optical imaging device (52) by the control (60) by means of an adjustable positioning device (282).

2. Exposure apparatus as defined in claim 1, **characterized in that** the light source unit (62) of the exposure device (54) is arranged separately from a bridge (40) guiding the optics slide (50).

3. Exposure apparatus as defined in claim 2, **characterized in that** the light source unit (62) is arranged on one side of the bridge (40).

4. Exposure apparatus as defined in any one of claims 1 to 3, **characterized in that** the light source unit (62) is movable with the optics unit (270) in the second direction (Y).

5. Exposure apparatus as defined in claim 4, **characterized in that** the light source unit (62) is guided on separate guides (66) provided for it.

6. Exposure apparatus as defined in claim 4 or 5, **characterized in that** the light source unit (62) is movable in the second direction (Y) by means of a linear drive (264).

7. Exposure apparatus as defined in any one of the preceding claims, **characterized in that** the exposure device (54) has a light source slide (64) movable in the second direction (Y), the light source unit (62) being arranged on said slide.

8. Exposure apparatus as defined in claim 7, **characterized in that** the light source slide (64) is driven such that it essentially follows the movements of the optics slide (50).

9. Exposure apparatus as defined in any one of the preceding claims, **characterized in that** the light source unit (62) is movable on guides (66') arranged outside the machine frame (12).

10. Exposure apparatus as defined in claim 9, **characterized in that** the light source unit (62) is arranged to the side next to an end side of the bridge (40).

11. Exposure apparatus as defined in any one of the preceding claims, **characterized in that** the flexible bundle of light guides (280) is guided in a trailing guide (420) provided on the bridge (40') and leading to the optics slide (50).

12. Exposure apparatus as defined in claim 11, **characterized in that** the trailing guide (420) runs in a receptacle (426) provided on the bridge (40').

13. Exposure apparatus as defined in claim 12, **characterized in that** the receptacle (426) is designed as a channel provided in the bridge (40').

14. Exposure apparatus as defined in any one of the preceding claims, **characterized in that** the positioning device (282) is designed such that it allows at least one exposure spot (294) generated by the optical imaging device (52) to be displaced on the photosensitive coating (30) in at least one direction (X, Y) parallel to a coating surface.

15. Exposure apparatus as defined in claim 14, **characterized in that** the positioning device (282) is designed such that it allows the at least one exposure spot (294) generated by the optical imaging device (52) to be displaced on the photosensitive coating (30) in two directions (X, Y) parallel to the coating surface (274) and extending transversely to one another.

16. Exposure apparatus as defined in any one of the preceding claims, **characterized in that** the end of the bundle of light guides (280) is movable relative to the optical imaging device (52) with the positioning device (282) in such a manner that a diameter of the at least one exposure spot generatable on the photosensitive coating is variable.

17. Exposure apparatus as defined in any one of the preceding claims, **characterized in that** a receiving unit (384) for the bundle of light guides (280) is movable relative to the optical imaging device (52) with the positioning device (282) in such a manner that a diameter of the at least one exposure spot (294) generatable on the photosensitive coating (30) is variable.

18. Exposure apparatus as defined in any one of the preceding claims, **characterized in that** the optical imaging device (52) is provided with an automatic focusing system (292).

19. Exposure apparatus as defined in any one of the preceding claims, **characterized in that** the positioning device (282) comprises a piezo drive as actuating drive.

20. Exposure apparatus as defined in any one of the preceding claims, **characterized in that** the optics slide (50) bears an optics unit (270) comprising the optical imaging device (52) and being movable relative to the optics slide (50).

21. Exposure apparatus as defined in claim 20, **characterized in that** the optics unit (270) is movable relative to the optics slide (50) in a third direction (Z) extending transversely to the first and second directions (X, Y).

22. Exposure apparatus as defined in any one of the preceding claims, **characterized in that** the optics unit (270) comprises an optical monitoring device (286) coupled to the optical imaging device (52).

23. Exposure apparatus as defined in claim 22, **characterized in that** the optical monitoring device (286) is provided with an optical illumination device (284).

24. Exposure apparatus as defined in any one of the preceding claims, **characterized in that** the optics slide (50) is guided on the machine frame (12) on a guide (40) extending above a movement area (36) of substrate slide and substrate member.

25. Exposure apparatus as defined in any one of the preceding claims, **characterized in that** a longitudinal measurement system (230) is provided for constantly detecting the position of the optics slide (50) in the second direction (Y) during the movement of the optics slide (50).

26. Exposure apparatus as defined in any one of the preceding claims, **characterized in that** a transverse measurement system (250) is provided for constantly detecting the position of the optics slide (50) transverse to the second direction (Y) during the movement of the optics slide (50).

27. Exposure apparatus as defined in claim 25 or 26, **characterized in that** the longitudinal measurement system (230) and/or the transverse measurement system (250) are optical measuring devices.

28. Exposure apparatus as defined in claim 27, **characterized in that** the optical measuring devices (230, 250) detect a light path interferometrically.

29. Exposure apparatus as defined in any one of the preceding claims, **characterized in that** the machine frame (12) has a base (14), a substrate slide (20) as substrate carrier being guided on said base so as to be movable in the first direction (X).

30. Exposure apparatus as defined in claim 29, **characterized in that** the base (14) is arranged on vibration-damping supports (16).

31. Exposure apparatus as defined in claim 29 or 30, **characterized in that** the machine frame (12) has a bridge (40) extending transversely to the first direction (X), an optics slide of the exposure device being guided on said bridge.

32. Exposure apparatus as defined in claim 31, **characterized in that** the bridge (40) is arranged on the base (14).

33. Exposure apparatus as defined in claim 31 or 32, **characterized in that** the substrate table (20) is movable relative to the bridge (40) in such a manner that the substrate table (20) is adapted to travel out completely from under the bridge (40) only on one side of the bridge (40).

34. Exposure apparatus as defined in any one of the preceding claims, **characterized in that** the substrate slide (20) is movable in the first direction by means of at least one electric linear drive.

35. Exposure apparatus as defined in claim 34, **characterized in that** the substrate table (20) is movable in the first direction (X) by means of two linear drives (90) arranged at a distance from one another.

36. Exposure apparatus as defined in any one of the preceding claims, **characterized in that** a substrate slide (20) designed as a substrate carrier is constructed as a supporting framework structure (100).

37. Exposure apparatus as defined in claim 36, **characterized in that** the supporting framework structure (100) of the substrate slide (20) has at least one surface structure (102, 104) and transversely to the surface structure (102, 104) a reinforcing structure (108) consisting of reinforcing walls (106) extending transversely to the surface structure (102, 104).

38. Exposure apparatus as defined in claim 37, **characterized in that** the surface structure is designed as an upper and/or lower wall (102, 104) of the substrate slide (20).

39. Exposure apparatus as defined in claim 37 or 38, **characterized in that** several reinforcing walls (106) are provided, said walls being connected to one another and forming an interconnected grating structure connected to the surface structure (102, 104).

40. Exposure apparatus as defined in any one of the preceding claims, **characterized in that** the substrate slide (20) is produced from a lightweight material.

41. Exposure apparatus as defined in claim 40, **characterized in that** the lightweight material is a fibre reinforced material.

42. Exposure apparatus as defined in claim 40 or 41, **characterized in that** the substrate slide (20) is produced from a C/SiC material.

43. Exposure apparatus as defined in any one of the preceding claims, **characterized in that** a rotor of the at least one linear drive (90) is arranged directly on the substrate slide (20).

44. Exposure apparatus as defined in claim 43, **characterized in that** the at least one rotor (94) is cooled in the area of a foot (114) provided for the mounting thereof.

45. Exposure apparatus as defined in claim 44, **characterized in that** the foot (114) of the at least one rotor (94) is penetrated by cooling channels (118).

46. Exposure apparatus as defined in any one of the preceding claims, **characterized in that** at least one momentum compensating slide (130) is provided, said slide being movable essentially in the opposite direction to the substrate slide (20).

47. Exposure apparatus as defined in claim 46, **characterized in that** the substrate slide (20) is arranged between two momentum compensating slides (130) movable in the opposite direction to it.

48. Exposure apparatus as defined in claim 46 or 47, **characterized in that** the at least one momentum compensating slide is driven by an electric linear drive.

49. Exposure apparatus as defined in any one of claims 46 to 48, **characterized in that** the at least one momentum compensating slide (130) is coupled electronically to the substrate slide (20) in the opposite direction.

50. Exposure apparatus as defined in any one of claims 46 to 49, **characterized in that** a centre of mass (150) of the substrate slide (20) and a centre of mass (152) of the at least one momentum compensating slide (130) are arranged in a common plane (154).

51. Exposure apparatus as defined in any one of the preceding claims, **characterized in that** a longitudinal measurement system (160) is provided for constantly detecting the position of the substrate slide (20) in the first direction (X) during the movement of the substrate slide (20).

52. Exposure apparatus as defined in any one of the preceding claims, **characterized in that** a transverse measurement system (180) is provided for constantly detecting the position of the substrate slide (20) transversely to the first direction (X) during the movement of the substrate slide (20).

53. Exposure apparatus as defined in claim 51 or 52, **characterized in that** the longitudinal measurement system (160) and the transverse measurement system (180) are designed as optical measuring systems.

54. Exposure apparatus as defined in claim 53, **characterized in that** the optical measuring system undertakes an interferometric distance measurement.

55. Exposure apparatus as defined in any one of the preceding claims, **characterized in that** at least one heat exchanger element (300) is arranged above a movement area (36) of a substrate slide (20) designed as a substrate carrier and of the substrate member (26), said element withdrawing heat from a gaseous cooling medium present in the movement area (36).

56. Exposure apparatus as defined in claim 55, **characterized in that** heat exchanger elements (300) are provided above the movement area (36) on both sides adjoining the bridge (40).

57. Exposure apparatus as defined in claim 55 or 56, **characterized in that** the heat exchanger element (300) has heat exchanger surfaces (306) extending in the direction of the movement area (36).

58. Exposure apparatus as defined in claim 57, **characterized in that** the heat exchanger surfaces (306) extend parallel to a predetermined direction (X).

59. Exposure apparatus as defined in claim 58, **characterized in that** the predetermined direction is the first direction (X).

60. Exposure apparatus as defined in any one of claims 48 to 59, **characterized in that** the heat exchanger surfaces (306) are arranged such that a flow channel (308) results, said flow channel extending in the predetermined direction (X).

61. Exposure apparatus as defined in any one of claims 55 to 60, **characterized in that** the heat exchanger element (300) is provided for the purpose of adjusting the temperature of an additional substrate member (26V).

62. Exposure apparatus as defined in claim 61, **characterized in that** the heat exchanger element (300) interacts with the substrate member (26V) to be temperature adjusted by way of bodily contact.

63. Exposure apparatus as defined in claim 61 or 62, **characterized in that** the heat exchanger element (300) is designed as a carrier for the substrate member (26V) to be temperature adjusted.

64. Exposure apparatus as defined in claim 62 or 63, **characterized in that** the substrate member (26) sits areally on the heat exchanger element.

65. Exposure apparatus as defined in any one of the preceding claims, **characterized in that** the movement area (36) of the substrate slide (20) and of the substrate member (26) has a flow of a temperature-stabilized gaseous cooling medium passing through it.

66. Exposure apparatus as defined in claim 65, **characterized in that** the flow (310) of the gaseous cooling medium flows over a coating surface (274) of the photosensitive coating (30).

67. Exposure apparatus as defined in claim 65 or 66, **characterized in that** the flow (310) of the gaseous cooling medium runs from a supply channel (324, 326) to a discharge channel (332).

68. Exposure apparatus as defined in claim 67, **characterized in that** the flow (310) of the gaseous cooling medium runs along the movement area (36) approximately parallel to the first direction (X).

69. Exposure apparatus as defined in claim 67 or 68, **characterized in that** a respective supply channel (324, 326) is arranged in an end area of the machine frame (12) located opposite the bridge (40).

70. Exposure apparatus as defined in claim 67 or 68, **characterized in that** at least one supply channel (324', 326') is arranged in the area of the bridge (40).

71. Exposure apparatus as defined in one of claims 67 to 68, **characterized in that** the discharge channel (332) is arranged in the area above the bridge (40).

72. Exposure apparatus as defined in any one of claims 67 to 71, **characterized in that** the flow (310, 330) of the gaseous cooling medium is guided through an optics movement area (328) arranged above the bridge (40).

73. Exposure apparatus as defined in claim 72, **characterized in that** the flow (310, 330) of the gaseous cooling medium in the optics movement area (328) flows first of all around the optics slide (50) with the optical imaging device (52) and then around the light source unit (62).

74. Exposure apparatus as defined in any one of claims 67 to 73, **characterized in that** the flow of the gaseous cooling medium is supplied to a reprocessing device (334) after the discharge thereof through the discharge channel (322).

75. Exposure apparatus as defined in any one of claims 65 to 74, **characterized in that** a flow (330) of the gaseous cooling medium flows along on a side of the heat exchanger element (300) facing the substrate member (26) on the substrate slide (20).

76. Exposure apparatus as defined in claim 75, **characterized in that** the flow (310) of the gaseous cooling medium flows through flow channels (308) arranged on this side of the heat exchanger element (300) and formed by the heat exchanger ribs (306).

77. Exposure apparatus as defined in any one of claims 65 to 76, **characterized in that** the substrate member (26V) to be temperature adjusted and arranged on the heat exchanger element (300) has a flow (330) of the gaseous cooling medium flowing over it on a side facing away from the substrate slide (20).

78. Exposure apparatus as defined in any one of claims 65 to 77, **characterized in that** the gaseous cooling medium flows under the optical imaging device (52) on its side facing the coating (30).

79. Exposure apparatus as defined in any one of the preceding claims, **characterized in that** a substrate feeder table (350) is provided, substrate members (26, 26V) being adapted to be supplied to the exposure apparatus via said table.

80. Exposure apparatus as defined in claim 79, **characterized in that** the substrate feeder table (350) is arranged so as to be vertically adjustable.

81. Exposure apparatus as defined in claim 80, **characterized in that** the substrate feeder table (350) is adjustable in such a manner that the substrate member (26, 26V) is displaceable without being offset vertically in a respective plane between the substrate feeder table (350) and the substrate slide (20) or the substrate feeder table (350) and the heat exchanger element (300).

82. Exposure apparatus as defined in any one of claims 79 to 81, **characterized in that** the substrate feeder table (350) and the substrate slide (20) or the substrate feeder table (350) and the heat exchanger element (300) are provided with devices (354, 358) for generating a cushion of air.

83. Exposure apparatus as defined in any one of the preceding claims, **characterized in that** the substrate member (26) is adapted to be fixed in position on the substrate slide (20) by means of suction elements (358).

## Revendications

1. Installation d'exposition pour des corps de substrat (26) qui portent un revêtement (30) photosensible sur une surface (28), comportant un bâti (12), un support de substrat (20) qui porte le corps de substrat (26), et un dispositif d'exposition (54), le corps de substrat (26) et le dispositif d'exposition (54) étant aptes à être déplacés l'un par rapport à l'autre dans une première direction (X) parallèle à une surface (28) du substrat et dans une deuxième direction (Y) parallèle à la surface (28) du substrat et orientée perpendiculairement à la première direction (X), de telle sorte que par ce mouvement relatif du dispositif d'exposition (54) par rapport au revêtement (30) photosensible dans la première direction (X) et dans la deuxième direction (Y), le revêtement (30) photosensible peut être insolé de manière sélective localement par des taches lumineuses (294) générées par le dispositif d'exposition (54), le dispositif d'exposition (54) comportant un chariot optique (50) mobile dans la deuxième direction (Y), sur lequel est disposée une optique de reproduction (52) pour l'insolation du corps de substrat (26), et le dispositif d'exposition (54) comportant une unité de source lumineuse (62), qui est disposée sur le bâti (12) en étant séparée du chariot optique (50) et dont le rayonnement peut être injecté dans l'optique de reproduction (52), et une commande (60),
**caractérisée en ce que** l'unité de source lumineuse (62) comporte une pluralité de sources lumineuses (61), **en ce qu'**au moins un faisceau de fibres optiques (280) flexible est guidé depuis l'unité de source lumineuse (62) vers l'optique de reproduction (52) contenue dans une unité optique (270), et **en ce qu'**une extrémité (386) du faisceau de fibres optiques (280) peut être positionnée par rapport à l'optique de reproduction (52) par la commande (60) au moyen d'un dispositif de positionnement (282) réglable.

2. Installation d'exposition selon la revendication 1, **caractérisée en ce que** l'unité de source lumineuse (62) du dispositif d'exposition (54) est agencée en étant séparée d'un pont (40) guidant le chariot optique (50).

3. Installation d'exposition selon la revendication 2, **caractérisée en ce que** l'unité de source lumineuse (62) est agencée sur un côté du pont (40).

4. Installation d'exposition selon l'une quelconque des revendications 1 à 3, **caractérisée en ce que** l'unité de source lumineuse (62) peut être déplacée avec l'unité optique (270) dans la deuxième direction (Y).

5. Installation d'exposition selon la revendication 4, **caractérisée en ce que** l'unité de source lumineuse (62) est guidée sur des glissières (66) séparées, prévues pour celle-ci.

6. Installation d'exposition selon la revendication 4 ou 5, **caractérisée en ce que** l'unité de source lumineuse (62) peut être déplacée dans la deuxième direction (Y) par un entraînement linéaire (264).

7. Installation d'exposition selon l'une quelconque des revendications précédentes, **caractérisée en ce que** le dispositif d'exposition (54) comporte un chariot pour sources lumineuses (64), qui est mobile dans la deuxième direction (Y) et sur lequel est agencée l'unité de source lumineuse (62).

8. Installation d'exposition selon la revendication 7, **caractérisée en ce que** le chariot pour sources lumineuses (64) est actionné de telle sorte qu'il suit sensiblement les mouvements du chariot optique (50).

9. Installation d'exposition selon l'une quelconque des revendications précédentes, **caractérisée en ce que** l'unité de source lumineuse (62) peut être déplacée sur des glissières (66') disposés en dehors du bâti (12).

10. Installation d'exposition selon la revendication 9, **caractérisée en ce que** l'unité de source lumineuse (62) est disposée latéralement à côté d'une face frontale du pont (40).

11. Installation d'exposition selon l'une quelconque des revendications précédentes, **caractérisée en ce que** le faisceau de fibres optiques (280) flexible est guidé dans une glissière d'entraînement (420), prévue sur le pont (40') et menant vers le chariot optique (50).

12. Installation d'exposition selon la revendication 11, **caractérisée en ce que** la glissière d'entraînement (420) s'étend dans un logement (426) prévu sur le pont (40').

13. Installation d'exposition selon la revendication 12, **caractérisée en ce que** le logement (426) est réalisé sous la forme d'un canal prévu dans le pont (40').

14. Installation d'exposition selon l'une quelconque des revendications précédentes, **caractérisée en ce que** le dispositif de positionnement (282) est réalisé de telle sorte qu'il permet de déplacer au moins une tache lumineuse (294), générée par l'optique de reproduction (52), sur le revêtement (30) photosensible dans au moins une direction (X, Y) parallèle à une surface du revêtement.

15. Installation d'exposition selon la revendication 14, **caractérisée en ce que** le dispositif de positionnement (282) est réalisé de telle sorte qu'il permet de déplacer ladite au moins une tache lumineuse (294), générée par l'optique de reproduction (52), sur le revêtement (30) photosensible dans deux directions (X, Y) parallèles à la surface de revêtement (274) et perpendiculaires entre elles.

16. Installation d'exposition selon l'une quelconque des revendications précédentes, **caractérisée en ce que** l'extrémité du faisceau de fibres optiques (280) peut être déplacée avec le dispositif de positionnement (282) par rapport à l'optique de reproduction (52), de manière à faire varier un diamètre de ladite au moins une tache lumineuse pouvant être générée sur le revêtement photosensible.

17. Installation d'exposition selon l'une quelconque des revendications précédentes, **caractérisée en ce qu'**une unité de réception (384) pour le faisceau de fibres optiques (280) peut être déplacée avec le dispositif de positionnement (282) par rapport à l'optique de reproduction (52) de manière à faire varier un diamètre de ladite au moins une tache lumineuse (294) pouvant être générée sur le revêtement (30) photosensible.

18. Installation d'exposition selon l'une quelconque des revendications précédentes, **caractérisée en ce que** l'optique de reproduction (52) est munie d'un système autofocus (292).

19. Installation d'exposition selon l'une quelconque des revendications précédentes, **caractérisée en ce que** le dispositif de positionnement (282) comporte un système d'entraînement piézoélectrique du type servomoteur.

20. Installation d'exposition selon l'une quelconque des revendications précédentes, **caractérisée en ce que** le chariot optique (50) porte une unité optique (270), qui comporte l'optique de reproduction (52) et qui peut être déplacée par rapport au chariot optique (50).

21. Installation d'exposition selon la revendication 20, **caractérisée en ce que** l'unité optique (270) peut être déplacée par rapport au chariot optique (50) dans une troisième direction (Z), orientée perpendiculairement à la première et à la deuxième direction (X, Y).

22. Installation d'exposition selon l'une quelconque des revendications précédentes, **caractérisée en ce que** l'unité optique (270) comporte une optique d'observation (286) couplée à l'optique de reproduction (52).

23. Installation d'exposition selon la revendication 22, **caractérisée en ce que** l'optique d'observation (286) est munie d'une optique d'éclairage (284).

24. Installation d'exposition selon l'une quelconque des revendications précédentes, **caractérisée en ce que** le chariot optique (50) est guidé sur le bâti (12) sur une glissière (40) qui s'étend sur une zone de mouvement (36) du chariot pour substrat et du corps de substrat.

25. Installation d'exposition selon l'une quelconque des revendications précédentes, **caractérisée en ce qu'**il est prévu un système de mesure longitudinale (230) qui, pendant le mouvement du chariot optique (50), enregistre en permanence la position du chariot optique (50) dans la deuxième direction (Y).

26. Installation d'exposition selon l'une quelconque des revendications précédentes, **caractérisée en ce qu'**il est prévu un système de mesure transversale (250) qui, pendant le mouvement du chariot optique (50), enregistre en permanence la position du chariot optique (50) perpendiculairement à la deuxième direction (Y).

27. Installation d'exposition selon la revendication 25 ou 26, **caractérisée en ce que** le système de mesure longitudinale (230) et/ou le système de mesure transversale (250) sont des dispositifs de mesure optiques.

28. Installation d'exposition selon la revendication 27, **caractérisée en ce que** les dispositifs de mesure optiques (230, 250) effectuent un enregistrement interférométrique d'une trajectoire de la lumière.

29. Installation d'exposition selon l'une quelconque des revendications précédentes, **caractérisée en ce que** le bâti (12) comporte une plaque de fondation (14), sur laquelle un chariot pour substrat (20) formant un support de substrat, est monté mobile dans la première direction (X).

30. Installation d'exposition selon la revendication 29, **caractérisée en ce que** la plaque de fondation (14) est agencée sur des pieds (16) amortissant les vibrations.

31. Installation d'exposition selon la revendication 29 ou 30, **caractérisée en ce que** le bâti (12) comporte un pont (40) qui s'étend transversalement à la première direction (X) et sur lequel est guidé un chariot optique du dispositif d'exposition.

32. Installation d'exposition selon la revendication 31, **caractérisée en ce que** le pont (40) est monté sur la plaque de fondation (14).

33. Installation d'exposition selon la revendication 31 ou 32, **caractérisée en ce que** la table pour substrat (20) est apte à être déplacée par rapport au pont (40), de telle sorte que la table pour substrat (20) peut être extraite totalement en dessous du pont (40) uniquement sur un côté du pont (40).

34. Installation d'exposition selon l'une quelconque des revendications précédentes, **caractérisée en ce que** le chariot pour substrat (20) peut être déplacé dans la première direction par au moins un entraînement linéaire électrique.

35. Installation d'exposition selon la revendication 34, **caractérisée en ce que** la table pour substrat (20) peut être déplacée dans la première direction (X) par l'intermédiaire de deux entraînements linéaires disposés à distance l'un de l'autre.

36. Installation d'exposition selon l'une quelconque des revendications précédentes, **caractérisée en ce qu'**un chariot pour substrat (20), réalisé sous forme de support du substrat, est configuré sous la forme d'une structure porteuse (100).

37. Installation d'exposition selon la revendication 36, **caractérisée en ce que** la structure porteuse (100) du chariot pour substrat (20) comporte au moins structure plane (102, 104) et, transversalement à la structure plane (102, 104), une structure de renfort (108) formée par des cloisons de renfort (106) orientées perpendiculairement à la structure plane (102, 104).

38. Installation d'exposition selon la revendication 37, **caractérisée en ce que** la structure plane est réalisée sous forme de paroi supérieure et/ou inférieure (102, 104) du chariot pour substrat (20).

39. Installation d'exposition selon la revendication 37 ou 38, **caractérisée en ce qu'**il est prévu plusieurs cloisons de renfort (106), qui sont reliées entre elles et forment une structure en réseau solidaire, qui est assemblée à la structure plane (102, 104).

40. Installation d'exposition selon l'une quelconque des revendications précédentes, **caractérisée en ce que** le chariot pour substrat (20) est réalisé dans un matériau pour construction légère.

41. Installation d'exposition selon la revendication 40, **caractérisée en ce que** le matériau pour construction légère est un matériau renforcé par des fibres.

42. Installation d'exposition selon la revendication 40 ou 41, **caractérisée en ce que** le chariot pour substrat (20) est réalisé dans un matériau à base de C/SiC.

43. Installation d'exposition selon l'une quelconque des revendications précédentes, **caractérisée en ce que** directement sur le chariot pour substrat (20) est agencé un rotor dudit au moins un entraînement linéaire (90).

44. Installation d'exposition selon la revendication 43, **caractérisée en ce que** ledit au moins un rotor (94) est refroidi dans la zone d'un pied (114) prévu pour le montage de celui-ci.

45. Installation d'exposition selon la revendication 44, **caractérisée en ce que** le pied (114) dudit au moins un rotor (94) est traversé par des conduits de refroidissement (118).

46. Installation d'exposition selon l'une quelconque des revendications précédentes, **caractérisée en ce qu'**il est prévu au moins un chariot de compensation des impulsions (130), qui peut être déplacé sensiblement dans le sens opposé par rapport au chariot pour substrat (20).

47. Installation d'exposition selon la revendication 46, **caractérisée en ce que** le chariot pour substrat (20) est agencé entre deux chariots de compensation des impulsions (130), aptes à se déplacer dans le sens opposé par rapport à celui-ci.

48. Installation d'exposition selon la revendication 46 ou 47, **caractérisée en ce que** ledit au moins un chariot de compensation des impulsions est actionné par entraînement linéaire électrique.

49. Installation d'exposition selon l'une quelconque des revendications 46 à 48, **caractérisée en ce que** ledit au moins un chariot de compensation des impulsions (130) est couplé électroniquement en sens opposé avec le chariot pour substrat (20).

50. Installation d'exposition selon l'une quelconque des revendications 46 à 49, **caractérisée en ce qu'**un centre de gravité (150) du chariot pour substrat (20) et un centre de gravité (152) dudit au moins un chariot de compensation des impulsions (130) sont disposés dans un plan commun (154).

51. Installation d'exposition selon l'une quelconque des revendications précédentes, **caractérisée en ce qu'**il est prévu un système de mesure longitudinale (160) qui, pendant le mouvement du chariot pour substrat (20), enregistre en permanence la position du chariot pour substrat (20) dans la première direction (X).

52. Installation d'exposition selon l'une quelconque des revendications précédentes, **caractérisée en ce qu'**il est prévu un système de mesure transversale (180) qui, pendant le mouvement du chariot pour substrat (20), enregistre en permanence la position du chariot pour substrat (20) perpendiculairement à la première direction (X).

53. Installation d'exposition selon la revendication 51 ou 52, **caractérisée en ce que** le système de mesure longitudinale (160) et/ou le système de mesure transversale (180) sont réalisés sous forme de systèmes de mesure optiques.

54. Installation d'exposition selon la revendication 53, **caractérisée en ce que** le système de mesure optique effectue une mesure interférométrique de la longueur.

55. Installation d'exposition selon l'une quelconque des revendications précédentes, **caractérisée en ce que** sur une zone de mouvement (36) d'un chariot pour substrat (20), réalisé sous forme de support de substrat, et du corps de substrat (26) est agencé au moins un élément échangeur thermique (300), qui retire la chaleur à un fluide de refroidissement gazeux, présent dans la zone de mouvement (36).

56. Installation d'exposition selon la revendication 55, **caractérisée en ce que** des éléments échangeurs thermiques (300) sont prévus au-dessus de la zone de mouvement (36), de part et d'autre dans le prolongement du pont (40).

57. Installation d'exposition selon la revendication 55 ou 56, **caractérisée en ce que** l'élément échangeur thermique (300) comporte des surfaces d'échange thermique (306) qui s'étendent dans la direction de la zone de mouvement (36).

58. Installation d'exposition selon la revendication 57, **caractérisée en ce que** les surfaces d'échange thermique (306) sont parallèles à une direction (X) prédéfinie.

59. Installation d'exposition selon la revendication 58, **caractérisée en ce que** la direction prédéfinie est la première direction (X).

60. Installation d'exposition selon l'une quelconque des revendications 48 à 59, **caractérisée en ce que** les surfaces d'échange thermique (306) sont disposées de telle sorte qu'il se forme un conduit d'écoulement (308), qui s'étend dans la direction (X) prédéfinie.

61. Installation d'exposition selon l'une quelconque des revendications 55 à 60, **caractérisée en ce que** l'élément échangeur thermique (300) est prévu pour tempérer un autre corps de substrat (26V).

62. Installation d'exposition selon la revendication 61, **caractérisée en ce que** l'élément échangeur thermique (300) interagit par contact corporel avec le corps de substrat (26V) à tempérer.

63. Installation d'exposition selon la revendication 61 ou 62, **caractérisée en ce que** l'élément échangeur thermique (300) est réalisé sous la forme d'un support pour le corps de substrat (26V) à tempérer.

64. Installation d'exposition selon la revendication 62 ou 63, **caractérisée en ce que** le corps de substrat (26) repose à plat sur l'élément échangeur thermique.

65. Installation d'exposition selon l'une quelconque des revendications précédentes, **caractérisée en ce que** la zone de mouvement (36) du chariot pour substrat (20) et du corps de substrat (26) est traversée par un flux d'un fluide de refroidissement gazeux à température stabilisée.

66. Installation d'exposition selon la revendication 65, **caractérisée en ce que** le flux (310) du fluide de refroidissement gazeux balaye une surface (274) du revêtement (30) photosensible.

67. Installation d'exposition selon la revendication 65 ou 66, **caractérisée en ce que** le flux (310) du fluide de refroidissement gazeux circule depuis un conduit d'admission (324, 326) vers un conduit d'évacuation (332).

68. Installation d'exposition selon la revendication 67, **caractérisée en ce que** le flux (310) du fluide de refroidissement gazeux circule le long de la zone de mouvement (36) à peu près parallèlement à la première direction (X).

69. Installation d'exposition selon la revendication 67 ou 68, **caractérisée en ce que** respectivement un conduit d'admission (324, 326) est disposé dans une zone d'extrémité du bâti (12), située face au pont (40).

70. Installation d'exposition selon la revendication 67 ou 68, **caractérisée en ce qu'**au moins un conduit d'admission (324', 326') est disposé dans la zone du pont (40).

71. Installation d'exposition selon l'une quelconque des revendications 67 à 68, **caractérisée en ce que** le conduit d'évacuation (332) est disposé dans la zone au-dessus du pont (40).

72. Installation d'exposition selon l'une quelconque des revendications 67 à 71, **caractérisée en ce que** le flux (310, 330) du fluide de refroidissement gazeux est guidé à travers une zone de mouvement optique (328), agencée au-dessus du pont (40).

73. Installation d'exposition selon la revendication 72, **caractérisée en ce que** le flux (310, 330) du fluide de refroidissement gazeux dans la zone de mouvement optique (328) circule d'abord autour du chariot optique (50) avec l'optique de reproduction (52), puis autour de l'unité de source lumineuse (62).

74. Installation d'exposition selon l'une quelconque des revendications 67 à 73, **caractérisée en ce que** le flux du fluide de refroidissement gazeux, après l'évacuation de celui-ci, est acheminé à travers le conduit d'évacuation (332) vers un dispositif de traitement (334).

75. Installation d'exposition selon l'une quelconque des revendications 65 à 74, **caractérisée en ce qu'**un flux (330) du fluide de refroidissement gazeux circule le long d'un côté de l'élément échangeur thermique (300), lequel est orienté vers le corps de substrat (26) sur le chariot pour substrat (20).

76. Installation d'exposition selon la revendication 75, **caractérisée en ce que** le flux (310) du fluide de refroidissement gazeux circule à travers des conduits d'écoulement (308) disposés sur ledit côté de l'élément échangeur thermique (300) et formés par les ailettes d'échange thermique (308).

77. Installation d'exposition selon l'une quelconque des revendications 65 à 76, **caractérisé en ce qu'**un flux (330) du fluide de refroidissement gazeux circule au-dessus du corps de substrat (26V) à tempérer, disposé sur l'élément échangeur thermique (300), sur un côté opposé au chariot pour substrat (20).

78. Installation d'exposition selon l'une quelconque des revendications 65 à 77, **caractérisée en ce que** le fluide de refroidissement gazeux circule au-dessous de l'optique de reproduction (52) sur son côté orienté vers le revêtement (30).

79. Installation d'exposition selon l'une quelconque des revendications précédentes, **caractérisée en ce qu'**il est prévu une table de chargement des substrats (350), par l'intermédiaire de laquelle les corps de substrats (26, 26V) sont aptes à être acheminés vers l'installation d'exposition.

80. Installation d'exposition selon la revendication 79, **caractérisée en ce que** la table de chargement des substrats (350) est réglable en hauteur.

81. Installation d'exposition selon la revendication 80, **caractérisée en ce que** la table de chargement des substrats (350) est réglable de telle sorte que le corps de substrat (26, 26V) peut être déplacé sans décalage de hauteur dans respectivement un plan entre la table de chargement des substrats (350) et le chariot pour substrat (20) ou la table de chargement des substrats (350) et l'élément échangeur thermique (300).

82. Installation d'exposition selon l'une quelconque des revendications 79 à 81, **caractérisée en ce que** la table de chargement des substrats (350) et le chariot pour substrat (20) ou la table de chargement des substrats (350) et l'élément échangeur thermique (300) sont munis de dispositifs (354, 358) destinés à générer un matelas d'air.

83. Installation d'exposition selon l'une quelconque des revendications précédentes, **caractérisée en ce que** le corps de substrat (26) peut être immobilisé sur le chariot pour substrat (20) par des éléments de succion (358).
